(19) Europäisches Patentamt
European Patent Office
Office européen des brevets

(11) EP 4 502 074 A1

(12) EUROPEAN PATENT APPLICATION
published in accordance with Art. 153(4) EPC

(43) Date of publication:
**05.02.2025 Bulletin 2025/06**

(21) Application number: **23779232.0**

(22) Date of filing: **03.03.2023**

(51) International Patent Classification (IPC):
***C08L 101/00*** *(2006.01)* ***C08K 3/00*** *(2018.01)*
***C08K 7/18*** *(2006.01)* ***C09K 11/02*** *(2006.01)*
***G02B 5/20*** *(2006.01)*

(52) Cooperative Patent Classification (CPC):
**C08F 2/44; C08K 3/00; C08K 3/01; C08K 7/18; C08L 101/00; C09K 11/02; C09K 11/70; C09K 11/88; G02B 5/20; G09F 9/30**

(86) International application number:
**PCT/JP2023/008023**

(87) International publication number:
**WO 2023/189203 (05.10.2023 Gazette 2023/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **31.03.2022 JP 2022059791**
**11.07.2022 JP 2022111365**

(71) Applicant: **Sumitomo Chemical Company, Limited**
**Tokyo 103-6020 (JP)**

(72) Inventors:
- **HAYASAKA KOMADA, Megumi**
  **Osaka-shi, Osaka 554-8558 (JP)**
- **NISHIKAWA YOSHINAGA, Yukako**
  **Osaka-shi, Osaka 554-8558 (JP)**
- **TOKUDA, Masayoshi**
  **Osaka-shi, Osaka 554-8558 (JP)**
- **TSUCHIYA, Mitsuo**
  **Osaka-shi, Osaka 554-8558 (JP)**

(74) Representative: **Vossius & Partner Patentanwälte Rechtsanwälte mbB**
**Siebertstrasse 3**
**81675 München (DE)**

(54) **COMPOSITION, FILM, AND DISPLAY DEVICE**

(57) Provided is a composition including a particle; wherein the particle includes: (A-1) a first particle having an average particle diameter d of $100 \times 10^{-7}$ cm or more; the composition further comprises at least one selected from the group consisting of a resin (C) and a polymerizable compound (D); and the composition has a sedimentation velocity v represented by a formula (i) of $400 \times 10^{-9}$ cm/s or less:

EP 4 502 074 A1

## Description

Technical Field

The present invention relates to a composition containing a particle and a film formed therefrom, and a display device including the film.

Background Art

Patent Literature 1 discloses a photosensitive resin composition for use in formation of a color filter, the composition containing a particle.

Citation List

Patent Literature

Patent Literature 1: International Publication No. 2014/157296

Summary of Invention

Technical Problem

A film exhibiting the desirable properties, including optical characteristics, can be prepared by forming a composition containing a particle having the properties into a film.

An object of the present invention is to provide a composition that contains a particle exhibiting the desired properties and can be formed into a film exhibiting the properties well. Another object of the present invention is to provide a film formed from the composition and a display device including the film.

Means to Solve the Problems

The present invention provides a composition, a film, and a display device as described below.

[1] A composition comprising a particle, wherein

the particle includes: (A-1) a first particle having an average particle diameter d of $100 \times 10^{-7}$ cm or more,
the composition further comprises at least one selected from the group consisting of a resin (C) and a polymerizable compound (D), and
the composition has a sedimentation velocity v represented by a formula (i) of $400 \times 10^{-9}$ cm/s or less:
[Expression 1]

$$v = \frac{g(\rho_s - \rho)d^2}{18\mu} \qquad \text{(i)}$$

wherein g represents a gravitational acceleration [cm/s$^2$], $\rho_s$ represents a density [g/cm$^3$] of the first particle (A-1), $\rho$ represents a density [g/cm$^3$] of the same composition as above except that the particle is not contained therein, and $\mu$ is a viscosity [g/(cm-s)] of the composition at 25°C.

[2] The composition according to [1], wherein the first particle (A-1) is a light-scattering particle.
[3] The composition according to [1] or [2], wherein the first particle (A-1) is an inorganic particle.
[4] The composition according to any one of [1] to [3], wherein the particle further includes: (A-2) a second particle having an average particle diameter of $50 \times 10^{-7}$ cm or less.
[5] The composition according to [4], wherein the second particle (A-2) is a light-emissive particle.
[6] The composition according to any one of [1] to [5], wherein the resin (C) is a resin having a polar group, and the polymerizable compound (D) is a polymerizable compound having a polar group.
[7] The composition according to [6], wherein the polar group is at least one group selected from the group consisting of a carboxy group, a thiol group, and an amino group.

[8] The composition according to any one of claims [1] to [7], wherein the composition is for forming an optical functional film.
[9] A film formed from the composition according to any one of [1] to [8].
[10] A display device comprising the film according to [9] .

Effects of Invention

According to present invention, it is possible to provide a composition that contains a particle exhibiting the desired properties and can be formed into a film exhibiting the properties well, and a film formed from the composition and a display device including the film.

Description of Embodiments

<Composition>

The composition according to the present invention (hereinafter also simply referred to as "composition") is a composition containing a particle. The particle includes: (A-1) a first particle having an average particle diameter d of $100 \times 10^{-7}$ cm (100 nm) or more. In addition to the first particle (A-1), the particle may include a second particle (A-2), which is different from the first particle (A-1). The composition further contains at least one binder component selected from the group consisting of a resin (C) and a polymerizable compound (D). Components that are contained or may be contained in the composition will be described below.
Herein, compounds listed as a component that is included or may be included in the composition can be used singly or in combinations of two or more, unless otherwise noticed.

[1] First particle (A-1)

The first particle (A-1) is generally a solid particle that can exhibit a specific property (function). The specific property is preferably an optical characteristic. A film obtained by forming the composition containing the first particle (A-1) into the film can exhibit the specific property (function), and can be an optical functional film (film having optical function), for example. The composition may contain one or more types of the first particle (A-1).
The first particle (A-1) has an average particle diameter d of $100 \times 10^{-7}$ cm (100 nm) or more. In a case where a composition containing a particle having such a relatively large particle diameter is formed into a film, there is a tendency unfortunately that the properties of the particle may not be exhibited well in the film. However, the present invention solves such a problem, and a film exhibiting the properties of the particle well can be formed. The average particle diameter d of the first particle (A-1) may be $150 \times 10^{-7}$ cm or more, $180 \times 10^{-7}$ cm or more, or $200 \times 10^{-7}$ cm or more. The average particle diameter d of the first particle (A-1) is generally $5000 \times 10^{-7}$ cm or less, and may be $1000 \times 10^{-7}$ cm or less, $800 \times 10^{-7}$ cm or less, $500 \times 10^{-7}$ cm or less, or $300 \times 10^{-7}$ cm or less.
The first particle (A-1) may be a light-scattering particle, but not limited thereto. The light-scattering particle has a function to scatter incident light. The film including the light-scattering particle can be used as a light-scattering film (light-diffusing film). As described later, the composition and the film can further contain a light-emissive particle as the second particle (A-2). In this case, the light-scattering particle can scatter the light emitted from the light-emissive particle to thereby fulfill a function to improve the emission intensity. In a case where the composition further contains the light-emissive particle as the second particle (A-2), the emission intensity of the film formed from the composition can be enhanced due to a sedimentation velocity v of $400 \times 10^{-9}$ cm/s or less, the sedimentation velocity v being represented by the formula (i), which will be described later in detail.
Examples of the light-scattering particle include an inorganic particle, such as a particle of metal and a metal oxide, and a glass particle. Examples of the metal oxide include $TiO_2$, $SiO_2$, $BaTiO_3$, and ZnO. In view of effectively scattering light, a particle of $TiO_2$ is preferable. The light-scattering particle may be an inorganic particle or an organic particle, but is preferably an inorganic particle. The light-scattering particle preferably has a high refractive index.
The refractive index of the first particle (A-1) is preferably 1.5 or more, more preferably 2.0 or more. As the refractive index, a value described in a known literature or catalog or a numerical value found in a general table of physical properties may be used.
The density $\rho_s$ of the first particle (A-1) is generally 6 g/cm$^3$ or less and generally 2.5 g/cm$^3$ or more. The first particle (A-1) may be a particle having a relatively large density $\rho_s$. When a composition is left to stand, a particle having a large density tends to settle down; on the other hand, according to the present invention, sediment of the particle is unlikely to occur, or in other words, a composition having an improved pot life can be provided. In this manner, a film exhibiting well the properties of the first particle (A-1) can be formed.
The density $\rho_s$ of the first particle (A-1) can be controlled by selection of the material for forming it. The density $\rho_s$

can also be controlled by a known method, including imparting the particle a hollow structure or imparting a core/shell structure having a surface layer made of a material with a small density.

The content ratio of the first particle (A-1) in the compound is, for example, 0.001% by mass or more and 50% by mass or less based on the total amount of the solids content of the composition. In view of enhancing the properties of the film brought about the first particle (A-1), the content ratio is preferably 0.01% by mass or more, more preferably 0.1% by mass or more, even more preferably 1% by mass or more, still more preferably 2% by mass or more, particularly preferably 5% by mass or more, and preferably 30% by mass or less, more preferably 15% by mass or less, even more preferably 10% by mass or less.

Herein, the total amount of the solids content means the total of the components excluding the solvent (H) among the components contained in the composition. The content ratio in the solids content of the composition can be determined by known analytical means such as liquid chromatography or gas chromatography. The content ratio of each component in the solids content of the composition may also be calculated from the formulation when the composition is prepared.

[2] Second particle (A-2)

The composition may contain the second particle (A-2), which is a particle different from the first particle (A-1). The second particle (A-2) is a particle having a smaller particle diameter than that of the first particle (A-1), and may have an average particle diameter of $50 \times 10^{-7}$ cm or less, for example. The composition may contain one or more types of the second particle (A-2). The second particle (A-2) is generally a solid particle that can exhibit a specific property (function). The specific property is preferably an optical characteristic. A film obtained by forming the composition containing the second particle (A-2) into the film can exhibit the specific property (function). Examples of the second particle (A-2) include, but not limited to, a light-emissive particle. Examples of the light-emissive particle include a light-emissive (fluorescent) semiconductor particle (hereinafter, also simply referred to as "semiconductor particle").

The semiconductor particle may be, for example, a red light-emissive semiconductor particle that emits light having an emission peak wavelength within the wavelength range of 605 nm or more and 665 nm or less; a green light-emissive semiconductor particle that emits light having an emission peak wavelength within the wavelength range of 500 nm or more and 560 nm or less; or a blue light-emissive semiconductor particle that emits light having an emission peak wavelength within the wavelength range of 420 nm or more and 480 nm or less. The semiconductor particle is preferably a red light-emissive semiconductor particle and/or a green light-emissive semiconductor particle. The emission peak wavelength of the semiconductor particle can be determined in the emission spectrum obtained using an ultra-violet and visible spectrophotometer, for example.

The full width at half maximum in the emission spectrum of the semiconductor particle is preferably 60 nm or less, more preferably 55 nm or less, even more preferably 50 nm or less, particularly preferably 45 nm or less. This allows for emission of light with higher color purity. The lower limit of the full width at half maximum in the emission spectrum of the semiconductor particle is not particularly limited, and the full width at half maximum may be 5 nm or more, or 15 nm or more.

The semiconductor particle is a particle of a semiconductor crystal, and preferably a nanoparticle of a semiconductor crystal. Preferred examples of the semiconductor particle include semiconductor quantum dots (hereinafter also referred to as "quantum dots") and a particle of a compound having a perovskite crystal structure (hereinafter also referred to as "perovskite compound"), and the semiconductor particle is more preferably quantum dots.

The average particle diameter of the quantum dots is, for example, $0.5 \times 10^{-7}$ cm or more and $20 \times 10^{-7}$ cm or less, preferably $1 \times 10^{-7}$ cm or more and $15 \times 10^{-7}$ cm or less (for example, $2 \times 10^{-7}$ cm or more and $15 \times 10^{-7}$ cm or less). Since the energy state of the quantum dots depends on its size, the emission wavelength can be freely selected by changing the particle size. For example, in a case of quantum dots made only of CdSe, the wavelengths of the peaks in an emission spectrum are 528 nm, 570 nm, 592 nm, and 637 nm when the particle diameters are $2.3 \times 10^{-7}$ cm, $3.0 \times 10^{-7}$ cm, $3.8 \times 10^{-7}$ cm, and $4.6 \times 10^{-7}$ cm, respectively.

The quantum dots may be, for example, made of a semiconductor material including one or more elements selected from the group consisting of group 2, group 11, group 12, group 13, group 14, group 15 and group 16 elements of the periodic table.

Specific examples of the semiconductor material that can form the quantum dots include:

a compound between a group 14 element and a group 16 element, such as $SnS_2$, SnS, SnSe, SnTe, PbS, PbSe, and PbTe;

a compound between a group 13 element and a group 15 element, such GaN, GaP, GaAs, GaSb, InN, InP, InAs, InSb, InGaN, and InGaP;

a compound between a group 13 element and a group 16 element, such as $Ga_2O_3$, $Ga_2S_3$, $Ga_2Se_3$, $Ga_2Te_3$, $In_2O_3$, $In_2S_3$, $In_2Se_3$, and $In_2Te_3$;

a compound between a group 12 element and a group 16 element, such as ZnO, ZnS, ZnSe, ZnTe, CdO, CdS, CdSe, CdTe, HgO, HgS, HgSe, HgTe, ZnSTe, ZnSeS, ZnSeTe, CdSTe, CdSeTe, HgSTe, HgSeS, and HgSeTe;

a compound between a group 15 element and a group 16 element, such as $As_2O_3$, $As_2S_3$, $As_2Se_3$, $As_2Te_3$, $Sb_2O_3$, $Sb_2S_3$, $Sb_2Se_3$, $Sb_2Te_3$, $Bi_2O_3$, $Bi_2S_3$, $Bi_2Se_3$, and $Bi_2Te_3$;

a compound between a group 2 element and a group 16 element, such as MgS, MgSe, MgTe, CaS, CaSe, CaTe, SrS, SrSe, SrTe, BaS, BaSe, and BaTe; and

a simple substance of a group 14 element, a group 15 element, or a group 16 element, such as Si and Ge.

The quantum dots may have a single layer structure made of a single semiconductor material, or may have a core/shell structure in which the surface of a core particle made of a single semiconductor material (core layer) is coated with a coating layer made of one or more semiconductor materials different from that of the core particle (shell layer). In the latter case, the semiconductor material used for the shell layer is generally a semiconductor material having a larger bandgap energy than that of the semiconductor material of the core layer. The quantum dots may have two or more shell layers. The shape of the quantum dots is not particularly limited, and may be spherical or almost spherical, rod-like, or disk-like, for example.

The perovskite compound is a compound having a perovskite crystal structure and containing components A, B, and X.

In the perovskite crystal structure, A is the component located at each vertex of the hexahedron having B as the center, and is a monovalent cation.

In the perovskite crystal structure, X is the component located at each vertex of the octahedron having B as the center, and is at least one ion selected from the group consisting of halide ions and a thiocyanate ion.

In the perovskite crystal structure, B is the component located at the centers of the hexahedron having A at the vertices and the octahedron having X at the vertices, and is a metal ion.

In view of favorably maintaining the crystal structure, the average particle diameter of the semiconductor particle made of the perovskite compound is preferably $3 \times 10^{-7}$ cm or more, more preferably $4 \times 10^{-7}$ cm or more, even more preferably $5 \times 10^{-7}$ cm or more, and generally $50 \times 10^{-7}$ cm or less.

The perovskite compound having component A, B, and X is not particularly limited, and may be a compound having any of a three-dimensional structure, a two-dimensional structure, and a pseudo two-dimensional structure.

In the case of the three-dimensional structure, the perovskite compound is represented by $ABX_{(3+\delta)}$.

In the case of the two-dimensional structure, the perovskite compound is represented by $A_2BX_{(4+\delta)}$.

$\delta$ is an appropriate variable number according to the charge balance of B, and is -0.7 or more and 0.7 or less.

Specific preferable examples of the perovskite compound having a three-dimensional structure of the perovskite crystal structure represented by $ABX_{(3+\delta)}$ include

$CH_3NH_3PbBr_3$, $CH_3NH_3PbCl_3$, $CH_3NH_3PbI_3$, $CH_3NH_3PbBr_{(3-y)}I_y$ $(0 < y < 3)$, $CH_3NH_3PbBr_{(3-y)}Cl_y$ $(0 < y < 3)$, $(H_2N{=}CH\text{-}NH_2)$ $PbBr_3$, $(H_2N{=}CH\text{-}NH_2)$ $PbCl_3$, $(H_2N{=}CH\text{-}NH_2)$ $PbI_3$,

$CH_3NH_3Pb_{(1-a)}Ca_aBr_3$ $(0 < a \leq 0.7)$, $CH_3NH_3Pb_{(1\ -a)}Sr_aBr_3$ $(0 < a \leq 0.7)$, $CH_3NH_3Pb_{(1-a)}La_aBr_{(3+\delta)}$ $(0 < a \leq 0.7, 0 < \delta \leq 0.7)$, $CH_3NH_3Pb_{(1-a)}Ba_aBr_3$ $(0 < a \leq 0.7)$, $CH_3NH_3Pb_{(1-a)}DyaBr_{(3+\delta)})$ $(0 < a \leq 0.7, 0 < \delta \leq 0.7)$,

$CH_3NH_3Pb_{(1-a)}Na_aBr_{(3+\delta)}$ $(0 < a \leq 0.7, -0.7 \leq \delta < 0)$, $CH_3NH_3Pb_{(1-a)}Li_aBr_{(3+\delta)}$ $(0 < a \leq 0.7, -0.7 \leq \delta < 0)$,

$CsPb_{(1-a)}Na_aBr_{(3+\delta)})$ $(0 < a \leq 0.7, -0.7 \leq \delta < 0)$, $CsPb_{(1-a)}Li_aBr_{(3+\delta)})$ $(0 < a \leq 0.7, -0.7 \leq \delta < 0)$,

$CH_3NH_3Pb_{(1-a)}Na_aBr_{(3+\delta-y)})I_y$ $(0 < a \leq 0.7, -0.7 \leq \delta < 0, 0 < y < 3)$, $CH_3NH_3Pb_{(1-a)}Li_aBr_{(3+\delta-y)}I_y$ $(0 < a \leq 0.7, -0.7 \leq \delta < 0, 0 < y < 3)$, $CH_3NH_3Pb_{(1-a)}Na_aBr_{(3+\delta-y)})Cl_y$ $(0 < a \leq 0.7, -0.7 \leq \delta < 0, 0 < y < 3)$, $CH_3NH_3Pb_{(1-a)}Li_aBr_{(3+\delta-y)}Cl_y$ $(0 < a \leq 0.7, -0.7 \leq \delta < 0, 0 < y < 3)$,

$(H_2N{=}CH\text{-}NH_2)Pb_{(1-a)}Na_aBr_{(3+\delta)}$ $(0 < a \leq 0.7, -0.7 \leq \delta < 0)$, $(H_2N{=}CH\text{-}NH_2)Pb_{(1-a)}Li_aBr_{(3+\delta)})$ $(0 < a \leq 0.7, -0.7 \leq \delta < 0)$, $(H_2N{=}CH\text{-}NH_2)Pb_{(1-a)}Na_aBr_{(3+\delta-y)})I_y$ $(0 < a \leq 0.7, -0.7 \leq \delta < 0, 0 < y < 3)$, $(H_2N{=}CH\text{-}NH_2)$ $Pb_{(1-a)}Na_aBr_{(3+8-y)}Cl_y$ $(0 < a \leq 0.7, -0.7 \leq \delta < 0, 0 < y < 3)$,

$CsPbBr_3$, $CsPbCl_3$, $CsPbI_3$, $CsPbBr_{(3-y)}I_y$ $(0 < y < 3)$, $CsPbBr_{(3-y)}Cl_y$ $(0 < y < 3)$, $CH_3NH_3PbBr_{(3-y)}Cl_y$ $(0 < y < 3)$, $CH_3NH_3Pb_{(1-a)}Zn_aBr_3$ $(0 < a \leq 0.7)$, $CH_3NH_3Pb_{(1-a)}Al_aBr_{(3+\delta)}$ $(0 < a \leq 0.7, 0 \leq \delta \leq 0.7)$, $CH_3NH_3Pb_{(1-a)}Co_aBr_3$ $(0 < a \leq 0.7)$, $CH_3NH_3Pb_{(1-a)}Mn_aBr_3$ $(0 < a \leq 0.7)$, $CH_3NH_3Pb_{(1-a)}Mg_aBr_3$ $(0 < a \leq 0.7)$,

$CsPb_{(1-a)}Zn_aBr_3$ $(0 < a \leq 0.7)$, $CsPb_{(1-a)}Al_aBr_{(3+\delta)}$ $(0 < a \leq 0.7, 0 < \delta \leq 0.7)$, $CsPb_{(1-a)}Co_aBr_3$ $(0 < a \leq 0.7)$, $CsPb_{(1-a)}Mn_aBr_3$ $(0 < a \leq 0.7)$, $CsPb_{(1-a)}Mg_aBr_3$ $(0 < a \leq 0.7)$,

$CH_3NH_3Pb_{(1-a)}Zn_aBr_{(3-y)}I_y$ $(0 < a \leq 0.7, 0 < y < 3)$, $CH_3NH_3Pb(_{1-a)}Al_aBr_{(3+8-y)}I_y$ $(0 < a \leq 0.7, 0 < \delta \leq 0.7, 0 < y < 3)$, $CH_3NH_3Pb_{(1-a)}Co_aBr_{(3-y)}I_y$ $(0 < a \leq 0.\ 7, 0 < y < 3)$, $CH_3NH_3Pb_{(1-a)}Mn_aBr_{(3-y)}I_y$ $(0 < a \leq 0.7, 0 < y < 3)$, $CH_3NH_3Pb_{(1-a)}Mg_aBr_{(3-y)}I_y$ $(0 < a \leq 0.7, 0 < y < 3)$, $CH_3NH_3Pb_{(1-a)}Zn_aBr_{(3-y)}Cl_y$ $(0 < a \leq 0.7, 0 < y < 3)$, $CH_3NH_3Pb_{(1-a)}Al_aBr_{(3+5-y)})Cl_y$ $(0 < a \leq 0.7, 0 < \delta \leq 0.7, 0 < y < 3)$, $CH_3NH_3Pb_{(1-a)}Co_aBr_{(3+\delta-y)})Cl_y$ $(0 < a \leq 0.7, 0 < y < 3)$, $CH_3NH_3Pb_{(1-a)}Mn_aBr_{(3-y)}Cl_y$ $(0 < a \leq 0.7, 0 < y < 3)$, $CH_3NH_3Pb_{(1-a)}Mg_aBr_{(3-y)}Cly$ $(0 < a \leq 0.7, 0 < y < 3)$,

$(H_2N{=}CH\text{-}NH_2)$ $Zn_aBr_3$ $(0 < a \leq 0.\ 7)$, $(H_2N{=}CH\text{-}NH_2)Mg_aBr_3$ $(0 < a \leq 0.7)$, $(H_2N{=}CH\text{-}NH_2)Pb_{(1-a)}Zn_aBr_{(3-y)}I_y$ $(0 < a \leq 0.7, 0 < y < 3)$, and $(H_2N{=}CH\text{-}NH_2)Pb_{(1-a)}Zn_aBr_{(3-y)}Cl_y$ $(0 < a \leq 0.7, 0 < y < 3)$ .

Specific preferable examples of the perovskite compound having a two-dimensional structure of the perovskite

crystal structure represented by $A_2BX_{(4+\delta)}$ include

$(C_4H_9NH_3)_2PbBr_4$, $(C_4H_9NH_3)_2PbCl_4$, $(C_4H_9NH_3)_2PbI_4$, $(C_7H_{15}NH_3)_2PbBr_4$, $(C_7H_{15}NH_3)_2PbCl_4$, $(C_7H_{15}NH_3)_2PbI_4$, $(C_4H_9NH_3)_2Pb_{(1-a)}Li_aBr_{(4+\delta)}$ $(0 < a \leq 0.7, -0.7 \leq \delta < 0)$, $(C_4H_9NH_3)_2Pb_{(1-a)}Na_aBr_{(4+\delta)}$ $(0 < a \leq 0.7, -0.7 \leq \delta < 0)$, $(C_4H_9NH_3)_2Pb_{(1-a)}Rb_aBr_{(4+\delta)}$ $(0 < a \leq 0.7, -0.7 \leq \delta < 0)$,
$(C_7H_{15}NH_3)_2Pb_{(1-a)}Na_aBr_{(4+\delta)}$ $(0 < a \leq 0.7, -0.7 \leq \delta < 0)$, $(C_7H_{15}NH_3)_2Pb_{(1-a)}Li_aBr_{(4+\delta)}$ $(0 < a \leq 0.7, -0.7 \leq \delta < 0)$, $(C_7H_{15}NH_3)_2Pb_{(1-a)}RbaBr_{(4+\delta)}$ $(0 < a \leq 0.7, -0.7 \leq \delta < 0)$,
$(C_4H_9NH_3)_2Pb_{(1-a)}Na_aBr_{(4+\delta-y)}I_y$ $(0 < a \leq 0.7, -0.7 \leq \delta < 0, 0 < y < 4)$, $(C_4H_9NH_3)_2Pb_{(1-a)}Li_aBr_{(4+\delta-y)}I_y$ $(0 < a \leq 0.7, -0.7 \leq \delta < 0, 0 < y < 4)$, $(C_4H_9NH_3)_2Pb_{(1-a)}Rb_aBr_{(4+\delta-y)}I_y$ $(0 < a \leq 0.7, -0.7 \leq \delta < 0, 0 < y < 4)$,
$(C_4H_9NH_3)_2Pb_{(1-a)}Na_aBr_{(4+\delta-y)}Cl_y$ $(0 < a \leq 0.7, -0.7 \leq \delta < 0, 0 < y < 4)$, $(C_4H_9NH_3)_2Pb_{(1-a)}Li_aBr_{(4+\delta-y)}Cl_y$ $(0 < a \leq 0.7, -0.7 \leq \delta < 0, 0 < y < 4)$, $(C_4H_9NH_3)_2Pb_{(1-a)}Pb_aBr_{(4+\delta-y)}Cl_y$ $(0 < a \leq 0.7, -0.7 \leq \delta < 0, 0 < y < 4)$,
$(C_4H_9NH_3)_2PbBr_4$, $(C_7H_{15}NH_3)_2PbBr_4$,
$(C_4H_9NH_3)_2PbBr_{(4-y)}Cl_y$ $(0 < y < 4)$, $(C_4H_9NH_3)_2PbBr_{(4-y)}I_y$ $(0 < y < 4)$,
$(C_4H_9NH_3)_2Pb_{(1-a)}Zn_aBr_4$ $(0 < a \leq 0.7)$, $(C_4H_9NH_3)_2Pb_{(1-a)}Mg_aBr_4$ $(0 < a \leq 0.7)$, $(C_4H_9NH_3)_2Pb_{(1-a)}Co_aBr_4$ $(0 < a \leq 0.7)$, $(C_4H_9NH_3)_2Pb_{(1-a)}Mn_aBr_4$ $(0 < a \leq 0.7)$,
$(C_7H_{15}NH_3)_2Pb_{(1-a)}Zn_aBr_4$ $(0 < a \leq 0.7)$, $(C_7H_{15}NH_3)_2Pb_{(1-a)}Mg_aBr_4$ $(0 < a \leq 0.7)$, $(C_7H_{15}NH_3)_2Pb_{(1-a)}Co_aBr_4$ $(0 < a \leq 0.7)$, $(C_7H_{15}NH_3)_2Pb_{(1-a)}Mn_aBr_4$ $(0 < a \leq 0.7)$,
$(C_4H_9NH_3)_2Pb_{(1-a)}Zn_aBr_{(4-y)}I_y$ $(0 < a \leq 0.7, 0 < y < 4)$, $(C_4H_9NH_3)_2Pb_{(1-a)}Mg_aBr_{(4-y)}I_y$ $(0 < a \leq 0.7, 0 < y < 4)$, $(C_4H_9NH_3)_2Pb_{(1-a)}CO_aBr_{(4-y)}I_y$ $(0 < a \leq 0.7, 0 < y < 4)$, $(C_4H_9NH_3)_2Pb_{(1-a)}Mn_aBr_{(4-y)}I_y$ $(0 < a \leq 0.7, 0 < y < 4)$,
$(C_4H_9NH_3)_2Pb_{(1-a)}Zn_aBr_{(4-y)}Cl_y$ $(0 < a \leq 0.7, 0 < y < 4)$, $(C_4H_9NH_3)_2Pb_{(1-a)}Mg_aBr_{(4-y)}Cl_y$ $(0 < a \leq 0.7, 0 < y < 4)$, $(C_4H_9NH_3)_2Pb_{(1-a)}Mg_aCo_{(4-y)}Cl_y$ $(0 < a \leq 0.7, 0 < y < 4)$, $(C_4H_9NH_3)_2Pb_{(1-a)}Mm_aBr_{(4-y)}Cl_y$ $(0 < a \leq 0.7, 0 < y < 4)$.

The semiconductor particle may a ligand-containing semiconductor particle that contains an organic ligand (G) coordinates with the semiconductor particle. The organic ligand (G) may be, for example, an organic compound having a polar group having capability to coordinate with the semiconductor particle. The organic ligand (G) may coordinate to the surface of the semiconductor particle, for example.

The organic ligand (G) may be a single type of ligand or may be two or more types of ligand. When the organic ligand (G) is an organic compound having a polar group, the organic ligand (G) generally coordinates with the semiconductor particle via the polar group. If the semiconductor particle is uniformly dispersed in a dispersing medium suitable for an organic ligand (G), it can be determined that the organic ligand (G) coordinates. Use of the ligand-containing semiconductor particle as a semiconductor particle may be advantageous in view of the stability and dispersibility of the semiconductor particle and improvement in the emission intensity.

The polar group of the organic ligand (G) is preferably at least one group selected from the group consisting of a thiol group (-SH), a carboxy group (-COOH), and an amino group ($-NH_2$). The polar group selected from the group can be advantageous in increasing the coordination property to the semiconductor particles. In particular, the polar group is more preferably at least one group selected from the group consisting of a thiol group and a carboxy group in view of improving the emission intensity. The organic ligand (G) may have one or more polar groups.

The organic ligand (G) may be, for example, an organic compound represented by the following formula (X) :

$$X^A\text{-}R^X \qquad (X)$$

In the formula, $X^A$ is the above-mentioned polar group, and $R^X$ is a monovalent hydrocarbon group which may contain a heteroatom (N, O, S, halogen atom, or the like). The hydrocarbon group may have one or two or more unsaturated bonds such as carbon-carbon double bonds.

The hydrocarbon group may have a linear, branched, or cyclic structure. The number of carbon atoms of the hydrocarbon group is, for example, 1 or more and 40 or less, and may be 1 or more and 30 or less. The methylene group contained in the hydrocarbon group is optionally replaced by -O-, -S-, -C(=O)-, -C(=O)-O-, -O-C(=O)-, - C(=O)-NH-, -NH-, or the like.

The group $R^X$ may contain a polar group. With respect to specific examples of the polar group, the above description relating to the polar group $X^A$ is referred to.

Specific examples of the organic ligand having a carboxy group as the polar group $X^A$ include formic acid, acetic acid, propionic acid, and saturated or unsaturated fatty acids. Specific examples of saturated or unsaturated fatty acids include saturated fatty acids such as butyric acid, pentanoic acid, caproic acid, caprylic acid, capric acid, lauric acid, myristic acid, pentadecylic acid, palmitic acid, margaric acid, stearic acid, arachidic acid, behenic acid, and lignoceric acid; monounsaturated fatty acids such as myristoleic acid, palmitoleic acid, oleic acid, icosenoic acid, erucic acid, and nervonic acid; and polyunsaturated fatty acids such as linoleic acid, α-linolenic acid, γ-linolenic acid, stearic acid, dihomo-γ-linolenic acid, arachidonic acid, eicosatetraenoic acid, docosadienoic acid, and adrenic acid (docosatetraenoic acid).

Specific examples of the organic ligand having a thiol group or an amino group as the polar group $X^A$ include

organic ligands in which the carboxy group of the organic ligands having a carboxy group as the polar group $X^A$ exemplified above is replaced by a thiol group or an amino group.

In addition to the above, examples of the organic ligand represented by the formula (X) include a compound (G-1) and a compound (G-2).

[Compound (G-1)]

The compound (G-1) is a compound having the first functional group and the second functional group. The first functional group is a carboxy group (-COOH), and the second functional group is a carboxy group or thiol group (-SH). Since the compound (G-1) has a carboxy group and/or a thiol group, it may serve as a ligand to coordinate with the semiconductor particle. The semiconductor particle may contain only a single kind of the compound (G-1) or two or more thereof.

An example of the compound (G-1) is a compound represented by the formula (G-1a) below. The compound (G-1) may be an acid anhydride of the compound represented by the formula (G-1a).

[Formula 1]

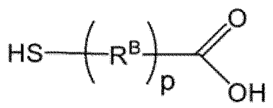

(G-1a)

[In the formula, $R^B$ represents a divalent hydrocarbon group. A plurality of $R^B$, when present, are optionally the same or different. The hydrocarbon group may have one or more substituents. When there are a plurality of substituents, they may be the same or different, and they may be bonded to each other to form a ring together with the atoms to which they are bonded.$-CH_2-$ contained in the hydrocarbon group is optionally replaced by at least one of -O-, -S-, $-SO_2-$, -CO-, and - NH-.

p represents an integer of 1 to 10.]

Examples of the divalent hydrocarbon group represented by $R^B$ include a chain hydrocarbon group, an alicyclic hydrocarbon group, and an aromatic hydrocarbon group.

Examples of the chain hydrocarbon group include a linear or branched alkanediyl group, and the number of carbon atoms thereof is generally 1 to 50, preferably 1 to 20, and more preferably 1 to 10. Examples of the alicyclic hydrocarbon group include a monocyclic or polycyclic cycloalkanediyl group, and the number of carbon atoms thereof is usually 3 to 50, preferably 3 to 20, and more preferably 3 to 10. Examples of the aromatic hydrocarbon group include a monocyclic or polycyclic arenediyl group, and the number of carbon atoms thereof is generally 6 to 20.

Examples of the substituent that the hydrocarbon group may have include an alkyl group having 1 to 50 carbon atoms, a cycloalkyl group having 3 to 50 carbon atoms, an aryl group having 6 to 20 carbon atoms, a carboxy group, an amino group, and a halogen atom. The substituent that the hydrocarbon group may have is preferably a carboxy group, an amino group, or a halogen atom.

When$-CH_2-$ contained in the hydrocarbon group is replaced by at least one of -O-, -CO-, and -NH-, $-CH_2-$ is preferably replaced by at least one of -CO- and -NH-, and more preferably -NH-. p is preferably 1 or 2.

Examples of the compound represented by the formula (G-1a) include compounds represented by the following formulas (1-1) to (1-9).

[Formula 2]

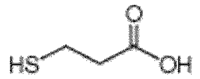 (1-1) 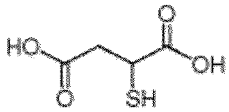 (1-2) 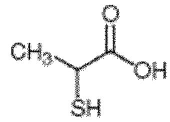 (1-3)

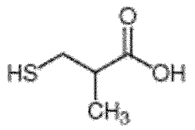 (1-4) 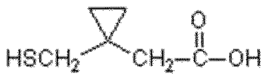 (1-5) 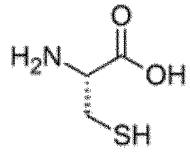 (1-6)

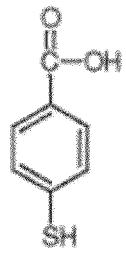 (1-7) 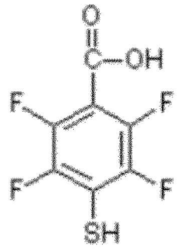 (1-8) 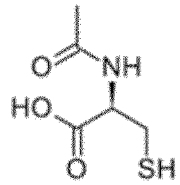 (1-9)

Specific examples of the compound represented by the formula (G-1a) include mercaptoacetic acid, 2-mercaptopropionic acid, 3-mercaptopropionic acid, 3-mercaptobutanoic acid, 4-mercaptobutanoic acid, mercaptosuccinic acid, mercaptostearic acid, mercaptooctanoic acid, 4-mercaptobenzoic acid, 2,3,5,6-tetrafluoro-4-mercaptobenzoic acid, L-cysteine, N-acetyl-L-cysteine, 3-methoxybutyl 3-mercaptopropionate, and 3-mercapto-2-methylpropionic acid. Of these, 3-mercaptopropionic acid and mercaptosuccinic acid are preferable.

Another example of the compound (G-1) is a polycarboxylic acid compound, preferably a compound (G-1b) in which -SH in the formula (G-1a) is replaced by a carboxy group (-COOH) in the compound represented by the formula (G-1a).

Examples of the compound (G-1b) include the following compounds:

Succinic acid, glutaric acid, adipic acid, octafluoroadipic acid, azelaic acid, dodecanedioic acid, tetradecanedioic acid, hexadecanedioic acid, heptadecanedioic acid, octadecanedioic acid, nonadecandioic acid, dodecafluorosuberic acid, 3-ethyl-3-methylglutaric acid, hexafluoroglutaric acid, trans-3-hexenedioic acid, sebacic acid, hexadecafluorosebacic acid, acetylenedicarboxylic acid, trans-aconitic acid, 1,3-adamantandicarboxylic acid, bicyclo[2.2.2]octane-1,4-dicarboxylic acid, cis-4-cyclohexene-1,2-dicarboxylic acid, 1,1-cyclopropanedicarboxylic acid, 1,1-cyclobutanedicarboxylic acid, cis- or trans-1,3-cyclohexanedicarboxylic acid, cis- or trans-1,4-cyclohexanedicarboxylic acid, 1,1-cyclopentanediacetic acid, 1,2,3,4-cyclopentanetetracarboxylic acid, decahydro-1,4-naphthalenedicarboxylic acid, 2,3-norbornanedicarboxylic acid, 5-norbornene-2,3-dicarboxylic acid, phthalic acid, 3-fluorophthalic acid, isophthalic acid, tetrafluoroisophthalic acid, terephthalic acid, tetrafluoroterephthalic acid, 2,5-dimethylterephthalic acid, 2,6-naphthalenedicarboxylic acid, 2,3-naphthalenedicarboxylic acid, 1,4-naphthalenedicarboxylic acid, 1,1'-ferrocenedicarboxylic acid, 2,2'-biphenyldicarboxylic acid, 4,4'-biphenyldicarboxylic acid, 2,5-furandicarboxylic acid, benzophenone-2,4'-dicarboxylic acid monohydrate, benzophenone-4,4'-dicarboxylic acid, 2,3-pyrazinedicarboxylic acid, 2,3-pyridinedicarboxylic acid, 2,4-pyridinedicarboxylic acid, 3,5-pyridinedicarboxylic acid, 2,5-pyridinedicarboxylic acid, 2,6-pyridinedicarboxylic acid, 3,4-pyridinedicarboxylic acid, pyrazole-3,5-dicarboxylic acid monohydrate, 4,4'-stilbenedicarboxylic acid, anthraquinone-2,3-dicarboxylic acid, 4-(carboxymethyl)benzoic acid, chelidonic acid monohydrate, azobenzene-4,4'-dicarboxylic acid, azobenzene-3,3'-dicarboxylic acid, chlorendic acid, 1H-imidazole-4,5-dicarboxylic acid, 2,2-bis(4-carboxyphenyl)hexafluoropropane, 1,10-bis(4-carboxyphenoxy)decane, dipropylmalonic acid, dithiodiglycolic acid, 3,3'-dithiodipropionic acid, 4,4'-dithiodibutanoic acid, 4,4'-dicarboxydiphenyl ether, 4,4'-dicarboxydiphenyl sulfone, ethylene glycol bis(4-carboxyphenyl)ether, 3,4-ethylenedioxythiophene-2,5-dicarboxylic acid, 4,4'-isopropylidenediphenoxyacetic acid, 1,3-acetonedicarboxylic acid, methylenedisalicylic acid, 5,5'-thiodisalicylic acid, tris(2-carboxyethyl)isocyanurate, tetrafluorosuccinic acid, $\alpha,\alpha,\alpha',\alpha'$-tetramethyl-1,3-benzenedipropionic acid, and 1,3,5-benzenetricarboxylic acid.

From the viewpoint of improving stability and dispersibility of the semiconductor particle and the emission intensity, the molecular weight of the compound (G-1) is preferably 3000 or less, more preferably 2500 or less, even more preferably 2000 or less, still more preferably 1000 or less, particularly preferably 800 or less, and most preferably 500 or less. The molecular weight of the compound (G-1) is generally 100 or more.

The molecular weight may be a number-average molecular weight or a weight-average molecular weight. In this case, the number-average molecular weight and the weight-average molecular weight are a number-average molecular weight and a weight-average molecular weight in terms of standard polystyrene measured by gel permeation chromatography (GPC), respectively.

In the case where the ligand-containing semiconductor particles contain the compound (G-1), the ratio of the content of the compound (G-1) to that of the semiconductor particle is preferably 0.001 or more and 1 or less, more

preferably 0.01 or more and 0.5 or less, and even more preferably 0.02 or more and 0.45 or less, in terms of mass ratio. The ratio between these contents within this range can be advantageous for improving stability and dispersibility of the semiconductor particle and the emission intensity.

[Compound (G-2)]

The compound (G-2) is a compound (G-2) different from the compound (G-1), and is a compound having a polyalkylene glycol structure and having a polar group at the molecular end. The molecular end is preferably the end of the longest carbon chain in the compound (G-2) (the carbon atom in the carbon chain is optionally replaced by another atom such as an oxygen atom).

The semiconductor particle may contain only one compound (G-2) or two or more thereof. The semiconductor particle may contain the compound (G-1) or the compound (G-2), or may be the compound (G-1) and the compound (G-2) .

Compounds having a polyalkylene glycol structure and having the first functional group and the second functional group are considered to belong to the compound (G-1) .

The polyalkylene glycol structure refers to a structure represented by the following formula:

[Formula 3]

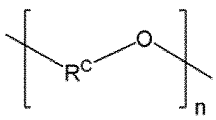

wherein n is an integer of 2 or more. In the formula, $R^C$ is an alkylene group, and examples thereof include an ethylene group and a propylene group.

Specific examples of the compound (G-2) include a polyalkylene glycol compound represented by the formula (G-2a) below.

[Formula 4]

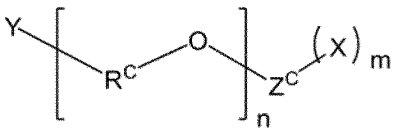

(G-2a)

In the formula (G-2a), X is a polar group, Y is a monovalent group, and $Z^C$ is a divalent or trivalent group. n is an integer of 2 or more. m is 1 or 2. $R^C$ is an alkylene group.

The polar group X is preferably at least one group selected from the group consisting of a thiol group (-SH), a carboxy group (-COOH), and an amino group ($-NH_2$). The polar group selected from the above-described group may be advantageous in terms of enhancing capability to coordinate with the semiconductor particle. Among these, the polar group X is more preferably at least one group selected from the group consisting of a thiol group and a carboxy group in view of enhancing the stability and dispersibility of the semiconductor particle and the emission intensity.

The group Y is a monovalent group. The group Y is not particularly limited, and examples thereof include a monovalent hydrocarbon group optionally having a substituent (N, O, S, a halogen atom, etc.). $-CH_2$-contained in the hydrocarbon group is optionally replaced by -O-, -S-, -C(=O)-, -C(=O)-O-, -O-C(=O)-, -C(=O)-NH-, - NH-, or the like. The number of carbon atoms of the hydrocarbon group is, for example, 1 or more and 12 or less. The hydrocarbon group may have an unsaturated bond.

Examples of the group Y include an alkyl group having a linear, branched, or cyclic structure having 1 or more and 12 or less carbon atoms; and an alkoxy group having a linear, branched, or cyclic structure having 1 or more and 12 or less carbon atoms. The number of carbon atoms of the alkyl group and the alkoxy group is preferably 1 or more and 8 or less, more preferably 1 or more and 6 or less, and still more preferably 1 or more and 4 or less. $-CH_2-$ contained in the alkyl group and the alkoxy group is optionally replaced by -O-, -S-, - C(=O)-, -C(=O)-O-, -O-C(=O)-, -C(=O)-NH-, -NH-, or the like. In particular, the group Y is preferably a linear or branched alkoxy group having 1 or more and 4 or less carbon atoms, and more preferably a linear alkoxy group having 1 or more and 4 or less carbon atoms.

The group Y may contain a polar group. Examples of the polar group include at least one group selected from the group consisting of a thiol group (-SH), a carboxy group (-COOH), and an amino group ($-NH_2$). However, as described above, compounds having a polyalkylene glycol structure and having the first functional group and the second functional group are considered to belong to the compound (G-1). The polar group is preferably located at the end of the group Y.

The group $Z^C$ is a divalent or trivalent group. The group $Z^C$ is not particularly limited, and examples thereof include a divalent or trivalent hydrocarbon group which may contain a heteroatom (N, O, S, halogen atom, or the like). The number of carbon atoms of the hydrocarbon group is, for example, 1 or more and 24 or less. The hydrocarbon group may have an unsaturated bond.

Examples of the group $Z^C$ which is a divalent group include an alkylene group having a linear, branched, or cyclic structure having 1 or more and 24 or less carbon atoms; and an alkenylene group having a linear, branched, or cyclic structure having 1 or more and 24 or less carbon atoms. The number of carbon atoms of the alkyl group and the alkenylene group is preferably 1 or more and 12 or less, more preferably 1 or more and 8 or less, and still more preferably 1 or more and 4 or less. $-CH_2-$contained in the alkyl group and the alkenylene group is optionally replaced by -O-, -S-, -C(=O)-, -C(=O)-O-, -O-C(=O)-, -C(=O)-NH-, -NH-, or the like. Examples of the group $Z^C$ which is a trivalent group include a group obtained by removing one hydrogen atom from the group $Z^C$ which is a divalent group described above.

The group $Z^C$ may have a branched structure. The group $Z^C$ having a branched structure may have a polyalkylene glycol structure different from the polyalkylene glycol structure represented by the formula (G-2a) in a branched chain different from the branched chain including the polyalkylene glycol structure represented by the formula (G-2a).

In particular, the group $Z^C$ is preferably a linear or branched alkylene group having 1 or more and 6 or less carbon atoms, and more preferably a linear alkylene group having 1 or more and 4 or less carbon atoms.

$R^C$ is an alkylene group, and is preferably a linear or branched alkylene group having 1 or more and 6 or less carbon atoms, and more preferably a linear alkylene group having 1 or more and 4 or less carbon atoms.

n in the formula (G-2a) is an integer of 2 or more, preferably 2 or more and 540 or less, more preferably 2 or more and 120 or less, and still more preferably 2 or more and 60 or less.

The molecular weight of the compound (G-2) can be, for example, about 150 or more and about 10000 or less, and is preferably 150 or more and 5000 or less, and more preferably 150 or more and 4000 or less, from the viewpoint of improving stability and dispersibility of the semiconductor particle and the emission intensity. The molecular weight may be a number-average molecular weight or a weight-average molecular weight. In this case, the number-average molecular weight and the weight-average molecular weight are a number-average molecular weight and a weight-average molecular weight in terms of standard polystyrene measured by GPC, respectively.

In the case where the ligand-containing semiconductor particles contain the compound (G-2), the ratio of the content of the compound (G-2) to that of the semiconductor particle is preferably 0.001 or more and 2 or less, more preferably 0.01 or more and 1.5 or less, and even more preferably 0.1 or more and 1 or less, in terms of mass ratio. The ratio between these contents within this range can be advantageous for improving stability and dispersibility of the semiconductor particle and the emission intensity.

When the semiconductor particle is the ligand-containing semiconductor particle, the ratio of the content of the organic ligand to the content of the semiconductor particle, in terms of mass, is preferably 0.001 or more and 1 or less, more preferably 0.01 or more and 0.8 or less, even more preferably 0.02 or more and 0.5 or less. The ratio between these contents within this range can be advantageous for improving stability and dispersibility of the semiconductor particle and the emission intensity. The content of the organic ligand here means the total content of all organic ligands.

The composition can contain a light-scattering particle as the first particle (A-1) and a light-emissive semiconductor particle as the second particle (A-2). When both of the light-scattering particle and the light-emissive semiconductor particle are contained, the light-scattering particle can be existed near the semiconductor particle, which may be advantageous in improvement in the emission intensity.

When the composition contains the second particle (A-2), the content ratio of the second particle (A-2) (provided that, the organic ligand (G) is excluded when the second particle is a ligand-containing semiconductor particle containing the organic ligand (G)) in the composition is, for example, 1% by mass or more and 70% by mass or less, based on the total amount of the solids content of the composition. In view of improving the properties (e.g., emission characteristics) of the film brought about the second particle (A-2), the content ratio is preferably 2% by mass or more, more preferably 5% by mass or more, even more preferably 8% by mass or more, still more preferably 10% by mass or more, and in view of the developability of the composition, the content ratio is preferably 65% by mass or less, more preferably 60% by mass or less, even more preferably 55% by mass or less, still more preferably 50% by mass or more, particularly preferably 48% by mass or less.

[3] Dispersant (B)

The composition may contain one or more types of dispersant (B). The dispersant (B) contained can enhance the dispensability of the first particle (A-1) in the composition. For example, the first particle (A-1) can be dispersed in a part or the whole of the solvent (H) with the dispersant (B) in advance, which can be used for preparation of the composition. The dispersant (B) does not encompass the organic ligand (G) described hereinabove, or a resin (Cb), which will be described later and can enhance the dispersibility of particles, or a polymerizable compound (Da), which will be described later and

can enhance the dispersibility of particles.

As the dispersant (B), commercially available products can be used. Examples of the commercially available products include:

DISPERBYK-101, 102, 103, 106, 107, 108, 109, 110, 111, 116, 118, 130, 140, 154, 161, 162, 163, 164, 165, 166, 170, 171, 174, 180, 181, 182, 183, 184, 185, 190, 192, 2000, 2001, 2020, 2025, 2050, 2070, 2095, 2150, 2155;ANTI-TERRA-U, U100, 203, 204, 250, ;BYK-P104, P104S, P105, 220S, 6919; BYK-LPN6919, 21116; LACTIMON, LACTIMON-WS; and Bykumen, all manufactured by BYK Japan KK;

SOLSPERSE-3000, 9000, 13000, 13240, 13650, 13940, 16000, 17000, 18000, 20000, 21000, 24000, 26000, 27000, 28000, 31845, 32000, 32500, 32550, 33500, 32600, 34750, 35100, 36600, 38500, 41000, 41090, 53095, 55000, and 76500, all manufactured by The Lubrizol Corporation;

EFKA-46, 47, 48, 452, 4008, 4009, 4010, 4015, 4020, 4047, 4050, 4055, 4060, 4080, 4400, 4401, 4402, 4403, 4406, 4408, 4300, 4310, 4320, 4330, 4340, 450, 451, 453, 4540, 4550, 4560, 4800, 5010, 5065, 5066, 5070, 7500, 7554, 1101, 120, 150, 1501, 1502, and 1503, all manufactured by BASF SE; and

AJISPER PA111, PB711, PB821, PB822, and PB824, all manufactured by Ajinomoto Fine-Techno Co., Inc.

The content ratio of the dispersant (B) in the composition is, for example, 0.001% by mass or more and 5% by mass or less based on the total amount of the solids content of the composition. The content ratio is preferably 0.05% by mass or more and 2% by mass or less, more preferably 0.1% by mass or more and 1% by mass or less, in view of enhancing the properties of the film brought about the first particle (A-1) and also the developability of the film and obtaining a sedimentation velocity v represented by the formula (i), which is described later in detail, of $400 \times 10^{-9}$ cm/s or less.

[4] Resin (C)

The composition contains at least one binder component selected from the group consisting of a resin (C) and a polymerizable compound (D). In a case where the composition contains the resin (C), one or more resins can be contained. Examples of the resin (C) include resins [K1] to [K4] below.

Resin [K1]: a copolymer of (a) at least one selected from the group consisting of an unsaturated carboxylic acid and an unsaturated carboxylic anhydride (hereinafter also referred to as "(a)"), and (c) a monomer copolymerizable with (a) (provided that this monomer is different from (a)) (hereinafter also referred to as (c) ") ;

Resin [K2]: a resin obtained by reacting the copolymer of (a) and (c), with (b) a monomer (b) having an ethylenically unsaturated bond and a cyclic ether structure with 2 to 4 carbon atoms (hereinafter also referred to as "(b)"), the resin having structures derived from (a), (c), and (b);

Resin [K3]: a resin obtained by reacting a copolymer of (b) and (c) with (a) and having structures derived from (b), (c), and (a); and

Resin [K4]: a resin obtained by reacting a copolymer of (b) and (c) with (a) and further reacting the resultant with a carboxylic anhydride, the resin having structures derived from (b), (c), (a), and the carboxylic anhydride.

Examples of (a) include unsaturated monocarboxylic acids such as (meth)acrylic acid, crotonic acid, and o-, m-, and p-vinylbenzoic acid;

unsaturated dicarboxylic acids such as maleic acid, fumaric acid, citraconic acid, mesaconic acid, itaconic acid, 3-vinylphthalic acid, 4-vinylphthalic acid, 3,4,5,6-tetrahydrophthalic acid, 1,2,3,6-tetrahydrophthalic acid, dimethyltetrahydrophthalic acid, and 1,4-cyclohexenedicarboxylic acid;

bicyclo unsaturated compounds containing a carboxy group, such as methyl-5-norbornene-2,3-dicarboxylic acid, 5-carboxybicyclo[2.2.1]hept-2-ene, 5,6-dicarboxybicyclo[2.2.1]hept-2-ene, 5-carboxy-5-methylbicyclo[2.2.1]hept-2-ene, 5-carboxy-5-ethylbicyclo[2.2.1]hept-2-ene, 5-carboxy-6-methylbicyclo[2.2.1]hept-2-ene, and 5-carboxy-6-ethylbicyclo[2.2.1]hept-2-ene;

unsaturated dicarboxylic acid anhydrides such as maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride, 5,6-dicarboxybicyclo[2.2.1]hept-2-ene anhydride;

unsaturated mono[(meth)acryloyloxyalkyl]esters of di- or higher polycarboxylic acids such as mono[2-(meth)acryloyloxyethyl]succinate and mono[2-(meth)acryloyoxyethyl]phthalate; and

unsaturated (meth)acrylates containing a hydroxy group and a carboxy group in the same molecule, such as $\alpha$-(hydroxymethyl) (meth)acrylic acid.

Of these, (meth) acrylic acid, maleic anhydride and the like are preferable from the viewpoint of copolymerization reactivity, for example.

Herein, "(meth)acrylic acid" means acrylic acid and/or methacrylic acid. The same also applies to "(meth)acryloyl", "(meth)acrylate", etc.

(b) is, for example, a monomer having a cyclic ether structure having 2 to 4 carbon atoms (for example, at least one selected from the group consisting of an oxirane ring, an oxetane ring, and a tetrahydrofuran ring) and an ethylenically unsaturated bond. (b) is preferably a monomer having a cyclic ether structure having 2 to 4 carbon atoms and a (meth) acryloyloxy group.

Examples of (b) include monomers having an oxirane ring and an ethylenically unsaturated bond, such as glycidyl (meth)acrylate, β-methylglycidyl (meth)acrylate, β-ethylglycidyl (meth)acrylate, glycidyl vinyl ether, o-vinylbenzyl glycidyl ether, m-vinylbenzyl glycidyl ether, p-vinylbenzyl glycidyl ether, α-methyl-o-vinylbenzyl glycidyl ether, α-methyl-m-vinylbenzyl glycidyl ether, α-methyl-p-vinylbenzyl glycidyl ether, 2,3-bis(glycidyloxymethyl)styrene, 2,4-bis(glycidyloxymethyl)styrene, 2,5-bis(glycidyloxymethyl) styrene, 2,6-bis(glycidyloxymethyl)styrene, 2,3,4-tris(glycidyloxymethyl) styrene, 2,3,5-tris(glycidyloxymethyl)styrene, 2,3,6-tris(glycidyloxymethyl) styrene, 3,4,5-tris(glycidyloxymethyl)styrene, and 2,4,6-tris(glycidyloxymethyl) styrene;

monomers having an oxetane ring and an ethylenically unsaturated bond, such as 3-methyl-3-methacryloyloxymethyloxetane, 3-methyl-3-acryloyloxymethyloxetane, 3-ethyl-3-methacryloyloxymethyloxetane, 3-ethyl-3-acryloyloxymethyloxetane, 3-methyl-3-methacryloyloxyethyloxetane, 3-methyl-3-acryloyloxyethyloxetane, 3-ethyl-3-methacryloyloxyethyloxetane, and 3-ethyl-3-acryloyloxyethyloxetane; and

monomers having a tetrahydrofuran ring and an ethylenically unsaturated bond, such as tetrahydrofurfuryl acrylate (for example, Viscoat V#150, manufactured by OSAKA ORGANIC CHEMICAL INDUSTRY LTD.) and tetrahydrofurfuryl methacrylate.

(b) is preferably a monomer having an oxirane ring and an ethylenically unsaturated bond, because the reactivity during the production of the resins [K2] to [K4] is high and unreacted (b) hardly remains.

Examples of (c) include (meth)acrylic esters such as methyl (meth)acrylate, ethyl (meth)acrylate, n-butyl (meth) acrylate, sec-butyl (meth)acrylate, tert-butyl (meth)acrylate, 2-ethylhexyl (meth)acrylate, dodecyl (meth)acrylate, lauryl (meth)acrylate, stearyl (meth)acrylate, cyclopentyl (meth)acrylate, cyclohexyl (meth)acrylate, 2-methylcyclohexyl (meth) acrylate, tricyclo [5.2.1.0$^{2,6}$] decan-8-yl (meth) acrylate (referred to as "dicyclopentanyl (meth)acrylate" (common name) in the art or sometimes referred to as "tricyclodecyl (meth)acrylate"), tricyclo[5.2.1.0$^{2,6}$]decen-8-yl (meth)acrylate (which is referred to as "dicyclopentenyl (meth)acrylate" (common name) in the art), dicyclopentanyloxyethyl (meth)acrylate, isobornyl (meth)acrylate, adamantyl (meth)acrylate, allyl (meth)acrylate, propargyl (meth)acrylate, phenyl (meth)acrylate, naphthyl (meth)acrylate, and benzyl (meth)acrylate;

hydroxy group-containing (meth)acrylic esters such as 2-hydroxyethyl (meth)acrylate and 2-hydroxypropyl (meth) acrylate;

dicarboxylic diesters such as diethyl maleate, diethyl fumarate, and diethyl itaconate;

bicyclo[2.2.1]hept-2-ene, 5-methylbicyclo[2.2.1]hept-2-ene, 5-ethylbicyclo[2.2.1]hept-2-ene, 5-hydroxybicyclo [2.2.1]hept-2-ene, 5-hydroxymethylbicyclo[2.2.1]hept-2-ene, 5-(2'-hydroxyethyl)bicyclo[2.2.1]hept-2-ene, 5-methoxybicyclo[2.2.1]hept-2-ene, 5-ethoxybicyclo[2.2.1]hept-2-ene, 5,6-dihydroxybicyclo[2.2.1]hept-2-ene, 5,6-di(hydroxymethyl)bicyclo[2.2.1]hept-2-ene, 5,6-di(2'-hydroxyethyl)bicyclo[2.2.1]hept-2-ene, 5,6-dimethoxybicyclo [2.2.1]hept-2-ene, 5,6-diethoxybicyclo[2.2.1]hept-2-ene, 5-hydroxy-5-methylbicyclo[2.2.1]hept-2-ene, 5-hydroxy-5-ethylbicyclo[2.2.1]hept-2-ene, 5-hydroxymethyl-5-methylbicyclo[2.2.1]hept-2-ene, 5-tert-butoxycarbonylbicyclo[2.2.1]hept-2-ene, 5-cyclohexyloxycarbonylbicyclo[2.2.1]hept-2-ene, 5-phenoxycarbonylbicyclo[2.2.1]hept-2-ene, 5,6-bis(tert-butoxycarbonyl)bicyclo[2.2.1]hept-2-ene, and 5,6-bis(cyclohexyloxycarbonyl)bicyclo[2.2.1] hept-2-ene;

dicarbonylimide derivatives such as N-phenylmaleimide, N-cyclohexylmaleimide, N-benzylmaleimide, N-succinimidyl-3-maleimidobenzoate, N-succinimidyl-4-maleimidobutyrate, N-succinimidyl-6-maleimide caproate, N-succinimidyl-3-maleimide propionate, and N-(9-acridinyl)maleimide; and

styrene, α-methylstyrene, m-methylstyrene, p-methylstyrene, vinyltoluene, p-methoxystyrene, acrylonitrile, methacrylonitrile, vinyl chloride, vinylidene chloride, acrylamide, methacrylamide, vinyl acetate, 1,3-butadiene, isoprene, and 2,3-dimethyl-1,3-butadiene.

Among these, from the viewpoint of copolymerization reactivity and heat resistance of the resin (C), styrene, vinyltoluene, N-phenylmaleimide, N-cyclohexylmaleimide, N-benzylmaleimide, bicyclo[2.2.1]hept-2-ene and the like are preferable.

In the resin [K1], the ratio of the structural units derived from each of (a) and (c) in the total structural units constituting the resin [K1] is preferably the following:

the structural unit derived from (a): 2 mol% or more and 60 mol% or less; and

the structural unit derived from (c): 40 mol% or more and 98 mol% or less,

and more preferably the following:

the structural unit derived from (a): 10 mol% or more and 50 mol% or less; and
the structural unit derived from (c): 50 mol% or more and 90 mol% or less.

When the ratio of the structural units in the resin [K1] are within the above-described range, the composition tends to be excellent in storage stability and to give a film having great resistance to solvents.

In a case where the resin (B) contains the structural unit derived from (a), the resin (B) can contain two or more structural unit derived from (a), and in that case, the ratio (the content ratio in terms of mole) of the structural unit derived from (a) is the total sum of the ratios of the structural units. The same also applies to a structural unit derived from another monomer, such as (b) and (c).

The resin [K1] can be produced with reference to the method disclosed in for example, a document "Experimental Method for Polymer Synthesis" (edited by Takayuki Otsu, published by Kagaku-Dojin Publishing Company, INC, First Edition, First Printed on Mar. 1, 1972) and cited documents described in the above-mentioned document.

Specific examples thereof include the following method: predetermined amounts of (a) and (c), a polymerization initiator, a solvent and the like are placed in a reaction vessel; for example, a deoxidization atmosphere is formed by replacing oxygen with nitrogen; and these are heated or kept warm during stirring.

The polymerization initiator, the solvent and the like which are used are not particularly limited, and those commonly used in the art can be used. Examples of the polymerization initiator include an azo compound (e.g., 2,2'-azobisisobutyronitrile, 2,2'-azobis(2,4-dimethylvaleronitrile)) and an organic peroxide (e.g., benzoyl peroxide). The solvent may be any solvent that dissolves the monomers, and examples thereof include solvents described later as a solvent (H), which may be contained in the composition.

A solution after a reaction, of the resultant copolymer may be directly used as it is,; a concentrated or diluted solution of the copolymer may be used; or a solid (powder) taken out from the copolymer by a method such as reprecipitation may be used. When the solvent (H) described later is used as the solvent for polymerization, the solution after the reaction can be directly used as it is for preparation of the composition, whereby the production process of the composition can be simplified.

The resin [K2] can be produced by adding a cyclic ether having 2 to 4 carbon atoms of (b) to the copolymer of (a) and (c), that is, to a carboxylic acid and/or a carboxylic acid anhydride of (a).

The copolymer of (a) and (c) is first produced in the same manner as in the method described as the method for producing the resin [K1]. In this case, the ratio of the structural units derived from each of (a) and (c) is preferably the same ratio as that described in the resin [K1] .

Next, a cyclic ether having 2 to 4 carbon atoms of (b) is reacted with a part of the carboxylic acid and/or the carboxylic acid anhydride derived from (a) in the copolymer.

Subsequent to the production of the copolymer of (a) and (c), the resin [K2] can be produced by replacing a nitrogen atmosphere in a flask with air, and reacting (b) in the presence of a reaction catalyst for a carboxylic acid or a carboxylic acid anhydride and a cyclic ether (for example, an organic phosphorus compound, a metallic complex, or an amine compound), and a polymerization inhibitor (for example, hydroquinone and the like), for example, at 60°C or more and 130°C or less for 1 to 10 hours.

The amount of (b) used is preferably 5 mol or more and 80 mol or less, and more preferably 10 mol or more and 75 mol or less, based on 100 mol of (a). When the amount of (b) is within this range, there is a tendency that storage stability of the composition and the solvent resistance of the film and heat resistance and mechanical strength of the film are well balanced.

Examples of the organic phosphorus compound as a reaction catalyst include triphenylphosphine. As the amine compound as the reaction catalyst, for example, an aliphatic tertiary amine compound or an aliphatic quaternary ammonium salt compound can be used, and specific examples thereof include tris(dimethylaminomethyl)phenol, triethylamine, tetrabutylammonium bromide, and tetrabutylammonium chloride. In view of optical characteristics of the film, including the emission intensity, the reaction catalyst is preferably an organophosphorous compound.

The amount of the reaction catalyst used is preferably 0.001 part by mass or more and 5 parts by mass or less based on 100 parts by mass of the total amount of (a), (b), and (c).

The amount of the polymerization inhibitor used is preferably 0.001 part by mass or more and 5 parts by mass or less based on 100 parts by mass of the total amount of (a), (b), and (c).

The reaction conditions such as the charging method, the reaction temperature and the time can be appropriately adjusted in consideration of the production equipment, the amount of heat generated by the polymerization, and the like. In the same manner as the polymerization conditions, the charging method and the reaction temperature can be appropriately adjusted in consideration of the production equipment, the amount of heat generated by the polymerization, and

the like.

The resin [K3] is produced by producing a copolymer of (b) and (c) in the same manner as in the above-mentioned method for producing the resin [K1] as a first step. In the same manner as in the above, a solution after a reaction, of the resultant copolymer may be used as it is; a concentrated or diluted solution of the copolymer may be used; or a solid (powder) taken out from the copolymer by a method such as reprecipitation may be used.

The ratio of the structural units derived from each of (b) and (c) based on the total number of moles of the total structural units constituting the copolymer is preferably the following:

the structural unit derived from (b): 5 mol% or more and 95 mol% or less; and
the structural unit derived from (c): 5 mol% or more and 95 mol% or less,

and more preferably the following:

the structural unit derived from (b): 10 mol% or more and 90 mol% or less; and
the structural unit derived from (c): 10 mol% or more and 90 mol% or less.

The resin [K3] can be produced by reacting a carboxylic acid or a carboxylic acid anhydride of (a) with the cyclic ether derived from (b) contained in the copolymer of (b) and (c) under the same conditions as those of the method for producing the resin [K2].

The amount of (a) used which is reacted with the copolymer is preferably 5 mol or more and 80 mol or less based on 100 mol of (b).

The resin [K4] is a resin obtained by further reacting the resin [K3] with a carboxylic acid anhydride. A carboxylic acid anhydride is reacted with a hydroxy group generated by a reaction between a cyclic ether and a carboxylic acid or a carboxylic anhydride.

Examples of the carboxylic acid anhydride include maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride, 5,6-dicarboxybicyclo[2.2.1]hept-2-ene anhydride.

The amount of the carboxylic acid anhydride used is preferably 0.5 mol or more and 1 mol or less based on 1 mol of the amount used in (a).

Examples of the resin [K1], the resin [K2], the resin [K3], and the resin [K4] include a resin [K1] such as a benzyl (meth)acrylate/(meth)acrylic acid copolymer and a styrene/(meth)acrylic acid copolymer;
a resin [K2] such as a resin produced by adding glycidyl (meth)acrylate to a benzyl (meth)acrylate/(meth)acrylic acid copolymer, a resin produced by adding glycidyl (meth)acrylate to a tricyclodecyl (meth)acrylate/styrene/(meth)acrylic acid copolymer, or a resin produced by adding glycidyl (meth)acrylate to a tricyclodecyl (meth)acrylate/benzyl (meth) acrylate/(meth)ac rylic acid copolymer; a resin [K3] such as a resin produced by reacting a tricyclodecyl (meth) acrylate/glycidyl (meth)acrylate copolymer with (meth)acrylic acid or a resin produced by reacting a tricyclodecyl (meth)acrylate/styrene/glycidyl (meth)acrylate copolymer with (meth)acrylic acid; and a resin [K4] such as a resin produced by reacting a tricyclodecyl (meth)acrylate/glycidyl (meth)acrylate copolymer with (meth)acrylic acid to produce a resin and then reacting this resin with tetrahydrophthalic anhydride.

As a further example of the resin (C), the resin disclosed in Japanese Patent Laid-Open No. 2018-123274 can be mentioned. Examples of the resin include a polymer (hereinafter also referred to as "resin (Ca)") which has a double bond in a side chain, includes a structural unit ($\alpha$) represented by the following formula (I) and a structural unit ($\beta$) represented by the following formula (II) in a main chain, and further includes an acid group.

The acid group may be introduced into the resin when, for example, the resin (Ca) contains a structural unit ($\gamma$) derived from an acid-containing monomer (for example, (meth)acrylic acid). The resin (Ca) preferably contains the structural units ($\alpha$), ($\beta$), and ($\gamma$) in the main chain skeleton.

[Formula 5]

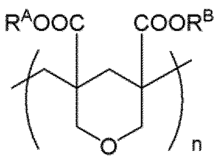

(I)

[In the formula, $R^A$ and $R^B$ are the same or different and each represent a hydrogen atom or a hydrocarbon group having 1 to 25 carbon atoms. n represents the average number of repeating units of the structural units represented by the formula (I), and is a number of 1 or more.]

[Formula 6]

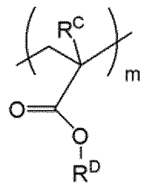

(II)

[In the formula, each $R^C$ is the same or different and represents a hydrogen atom or a methyl group. Each $R^D$ is the same or different and represents a linear or branched chain hydrocarbon group having 4 to 20 carbon atoms. m represents the average number of repeating units of the structural units represented by the formula (II), and is a number of 1 or more.]

The content proportion of the structural unit ($\alpha$) in the resin (Ca) is, for example, from the viewpoint of heat resistance and storage stability of the resin (Ca), 0.5% by mass or more and 50% by mass or less, preferably 1% by mass or more and 40% by mass or less, and more preferably 5% by mass or more and 30% by mass or less based on 100% by mass of the total amount of all monomer units that give the main chain skeleton of the resin (Ca). In the formula (I), n represents the average number of repeating units of the structural unit ($\alpha$) in the resin (Ca), and n can be set so that the content proportion of the structural unit ($\alpha$) falls within the above range.

The content proportion of the structural unit ($\beta$) is, for example, from the viewpoint of the solvent resistance of the film, 10% by mass or more and 90% by mass or less, preferably 20% by mass or more and 80% by mass or less, and more preferably 30% by mass or more and 75% by mass or less, based on 100% by mass of the total amount of all monomer units that give the main chain skeleton of the resin (Ca). In the formula (II), m represents the average number of repeating units as the structural unit ($\beta$) in the resin (Ca), and m can be set so that the content proportion of the structural unit ($\beta$) falls within the above range.

The content proportion of the structural unit ($\gamma$) is, for example, from the viewpoint of the solubility of the resin (Ca) in the solvent (H), 0.5% by mass or more and 50% by mass or less, preferably 2% by mass or more and 50% by mass or less, and more preferably 5% by mass or more and 45% by mass or less, based on 100% by mass of the total amount of all monomer units that give the main chain skeleton of the resin (Ca).

Still another example of the resin (C) is a polyalkylene glycol compound. Examples of the polyalkylene glycol compound include polyethylene glycol and polypropylene glycol.

The resin (C) preferably has a weight average molecular weight (Mw) of 9000 or less, in terms of standard polystyrene, as determined by gel permeation chromatography (GPC). When the resin (C) has the above-described Mw, a resulting film tends to have improved optical characteristics of the film, including the emission intensity. The Mw, in terms of standard polystyrene, of the resin (C) is, for example, 1000 or more and 9000 or less, and in view of optical characteristics of the film, including the emission intensity, preferably 2000 or more and 8500 or less, more preferably 3000 or more and 8500 or less.

For obtaining a Mw of the resin (C) within the above-described range, the conditions for the reaction can be appropriately controlled in combination, including selection of starting materials used and the manner of adding them, the reaction temperature, and the reaction time.

The distribution of the molecular weight, [weight average molecular weight (Mw)/number-average molecular weight (Mn)], of the resin (C) as determined by GPC is, for example, 1.0 or more and 6.0 or less, and in view of enhancing the optical characteristics of the film, preferably 1.2 or more and 4.0 or less.

In view of enhancing the optical characteristics and the solvent resistance of the film, the acid value of the resin (C) is preferably 90 mg KOH/g or more and 150 mg KOH/g or less, more preferably 95 mg KOH/g or more and 140 mg KOH/g or less, even more preferably 100 mg KOH/g or more and 130 mg KOH/g or less. The acid value is a value as determined in terms of the amount (mg) of potassium hydroxide necessary for neutralizing 1 g of the resin (C), and can be determined by, for example, titrating the resin with an aqueous potassium hydroxide solution.

In view of enhancing the optical characteristics of the film, the resin (C) preferably includes a resin having a double bond equivalent of 300 g/eq or more 2000 g/eq or less, and more preferably includes a resin having a double bond equivalent of 500 g/eq or more 1500 g/eq or less. Examples of the resin having a double bond equivalent of 300 g/eq or more 2000 g/eq or less include a (meth)acrylic resin. The resin (C) preferably consists of a (meth)acrylic resin.

The resin (C) preferably includes: (Cb) a resin that can enhance dispersibility of particles, and the resin (C) is more preferably the resin (Cb). Examples of the resin (Cb) include a resin having a polar group. The polar group is capable of adsorbing the first particle (A-1) and the second particle (A-2). Accordingly, the resin (C) that includes the resin (Cb) is advantageous in terms of reducing the sedimentation velocity v represented by the formula (i). The polar group may be at least one group selected from the group consisting of a carboxy group (-COOH), a thiol group (-SH) and an amino group ($-NH_2$), and the polar group is preferably a carboxy group. The resin (Cb) may have two or more types of the polar group.

In a case where the composition contains the resin (C), the content ratio of the resin (C) in the composition is, for

example, 5% by mass or more, preferably 10% by mass or more, more preferably 15 % by mass or more, even more preferably 20% by mass or more, particularly preferably 25% by mass or more, and for example, 90% by mass or less, preferably 85% by mass or less, more preferably 80 %by mass or less, based on the total amount of the solids content of the composition. When the content ratio of the resin (C) is within the above-described range, there is a tendency that optical characteristics of the film are enhanced.

[5] Polymerizable compound (D)

The composition may contain a polymerizable compound (D). The polymerizable compound (D) is a compound that is polymerizable due to, for example, an active radial or an acid generated from the polymerization initiator (E), which will be described later. The composition may contain two or more kinds of the polymerizable compounds (D). In a case where the composition contains the resin (C), the composition may or may not contain the polymerizable compound (D). In a case where the composition contains no resin (C), the composition contains the polymerizable compound (D).
Examples of the polymerizable compound (D) include a photopolymerizable compound, which is cured by irradiation with light, and a thermally polymerizable compound, which is cured by heat. Examples of the photopolymerizable compound include a radically photopolymerizable compound, which is cured through a radical polymerization reaction by irradiation with light, and a cationically photopolymerizable compound, which is cured through a cation polymerization reaction by irradiation with light. The photopolymerizable compound is preferably the radically photopolymerizable compound.
The photopolymerizable compound has a weight-average molecular weight of, for example, 150 or more and 3000 or less, preferably 150 or more and 2900 or less, more preferably 250 or more and 1500 or less.
Examples of the radically photopolymerizable compound include a compound having a polymerizable, ethylenically unsaturated bond, and among others, a (meth)acrylate compound is preferable. Examples of the (meth)acrylate compound include a monofunctional (meth)acrylate monomer having a single (meth)acryloyloxy group per molecule (hereinafter, also referred to as "compound (D-1)"), a bifunctional (meth)acrylate monomer having two (meth)acryloyloxy groups per molecule (hereinafter, also referred to as "compound (D-2)"), and a polyfunctional (meth)acrylate monomer having three or more (meth)acryloyloxy groups per molecule (hereinafter, also referred to as "compound (D-3)").
Examples of the compound (D-1) include methyl (meth)acrylate, ethyl (meth)acrylate, propyl (meth)acrylate, butyl (meth)acrylate, amyl (meth)acrylate, hexyl (meth)acrylate, 2-ethylhexyl (meth)acrylate, octyl (meth)acrylate, nonyl (meth)acrylate, dodecyl (meth)acrylate (lauryl (meth)acrylate), hexadecyl (meth)acrylate, octadecyl (meth)acrylate, cyclohexyl (meth)acrylate, methoxyethyl (meth)acrylate, butoxyethyl (meth)acrylate, phenoxyethyl (meth)acrylate, nonylphenoxyethyl (meth)acrylate, glycidyl (meth)acrylate, dimethylaminoethyl (meth)acrylate, diethylaminoethyl (meth) acrylate, isobornyl (meth)acrylate, dicyclopentanyl (meth)acrylate, dicyclopentenyl (meth)acrylate, dicyclopentenyloxyethyl (meth)acrylate, 2-hydroxy-3-phenoxypropyl (meth)acrylate, tetrahydrofurfuryl (meth)acrylate, 2-hydroxyethyl (meth)acrylate, benzyl (meth)acrylate, phenyl(meth)acrylate, mono(2-acryloyloxyethyl) succinate, N-[2-(acryloyloxy) ethyl]phthalimide, N-[2 - (acryloyloxy)ethyl] tetrahydrophthalimide, 2-(2-vinyloxyethoxy)ethyl (meth)acrylate, ω-carboxy-polycaprolactone monoacrylate, ethylcarbitol (meth)acrylate (ethoxyethoxyethyl (meth)acrylate), and 3,3,5-trimethylcyclohexyl (meth)acrylate.
Examples of the compound (D-2) include 1,3-butylene glycol di(meth)acrylate, 1,4-butanediol di(meth)acrylate, 1,5-pentanediol di(meth)acrylate, 3-methyl-1,5-pentanediol di(meth)acrylate, 1,6-hexanediol di(meth)acrylate, neopentyl glycol di(meth)acrylate, 1,8-octanediol di(meth)acrylate, 1,9-nonanediol di(meth)acrylate, tricyclodecanedimethanol di(meth)acrylate, ethylene glycol di(meth)acrylate, polyethylene glycol di(meth)acrylate, propylene glycol di(meth)acrylate, dipropylene glycol di(meth)acrylate, tripropylene glycol di(meth)acrylate, polypropylene glycol di(meth)acrylate, neopentyl glycol hydroxypivalate ester di(meth)acrylate, di(meth)acrylate obtained by replacing two hydroxy groups of tris(2-hydroxyethyl)isocyanurate by (meth)acryloyloxy groups, di(meth)acrylate obtained by adding four or more moles of ethylene oxide or propylene oxide to one mole of neopentyl glycol to obtain a diol and replacing two hydroxy groups of the diol by (meth)acryloyloxy groups, di(meth)acrylate obtained by adding two moles of ethylene oxide or propylene oxide to one mole of bisphenol A to obtain a diol and replacing two hydroxy groups of the diol by (meth)acryloyloxy groups, di(meth) acrylate obtained by adding three or more moles of ethylene oxide or propylene oxide to one mole of trimethylolpropane to obtain a triol and replacing two hydroxy groups of the triol by (meth)acryloyloxy groups, and di(meth)acrylate obtained by adding four or more moles of ethylene oxide or propylene oxide to one mole of bisphenol A to obtain a diol and replacing two hydroxy groups of the diol by (meth)acryloyloxy groups.
Examples of the compound (D-3) include glycerol tri(meth)acrylate, trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, tripentaerythritol octa(meth)acrylate, tripentaerythritol hepta(meth)acrylate, tetrapentaerythritol deca(meth)acrylate, tetrapentaerythritol nona(meth)acrylate, tris(2-(meth)acryloyloxyethyl)isocyanurate, ethylene glycol-modified pentaerythritol tetra(meth)acrylate, ethylene glycol-modified dipentaerythritol hexa(meth)acrylate, propylene glycol-modified pentaerythritol tetra(meth)acrylate, propylene glycol-modified dipentaerythritol hexa(meth)acrylate, caprolactone modified pentaerythritol tetra(meth)acrylate, caprolactone modified dipentaerythritol hexa(meth) acrylate, monosuccinate of pentaerythritol triacrylate, mono succinate of dipentaerythritol pentaacrylate, monomaleate of pentaerythritol triacrylate, and monomaleate of dipentaerythritol pentaacrylate.

Examples of the cationically photopolymerizable compound include a compound having at least one oxetane ring (4-membered ring ether) per molecule (hereinafter simply referred to as "oxetane compound"), a compound having at least one oxirane ring (3-membered ring ether) per molecule (hereinafter simply referred to as "epoxy compound"), and a vinyl ether compound.

Examples of the oxetane compound include 3-ethyl-3-hydroxymethyloxetane, 1,4-bis[(3-ethyl-3-oxetanyl) methoxymethyl]benzene, 3-ethyl-3-(phenoxymethyl)oxetane, di[(3-ethyl-3-oxetanyl)methyl]ether, 3-ethyl-3-(2-ethylhexyloxymethyl)oxetane, and phenolic novolac oxetane. These oxetane compounds can be easily obtained as commercially available products, and examples of the commercially available products include "ARON OXETANE (registered trademark) OXT-101", "ARON OXETANE (registered trademark) OXT-121", "ARON OXETANE (registered trademark) OXT-211", "ARON OXETANE (registered trademark) OXT-221", and "ARON OXETANE (registered trademark) OXT-212", which are all product names and manufactured by TOAGOSEI CO., LTD.

Examples of the epoxy compound include an aromatic epoxy compound, a glycidyl ether of a polyol having an alicyclic ring, an aliphatic epoxy compound, and an alicyclic epoxy compound.

Examples of the aromatic epoxy compound include a bisphenol epoxy resin, such as diglycidyl ether of bisphenol A, diglycidyl ether of bisphenol F, and diglycidyl ether of bisphenol S; a novolac epoxy resin, such as a phenolic novolac epoxy resin, a cresol novolac epoxy resin, and a hydroxybenzaldehyde phenolic novolac epoxy resin; and a multifunctional epoxy resin, such as glycidyl ether of tetrahydroxyphenylmethane, glycidyl ether of tetrahydroxybenzophenone, and epoxidized polyvinylphenol.

Examples of the glycidyl ether of a polyol having an alicyclic ring include that obtained by selectively hydrogenating the aromatic ring of an aromatic polyol under pressure in the presence of a catalyst to thereby obtain a nuclear-hydrogenated polyhydroxy compound, and subjecting the compound to glycidyl etherification. Examples of the aromatic polyol include a bisphenol compound, such as Bisphenol A, Bisphenol F, and Bisphenol S; a novolac resin, such as a phenolic novolac resin, a cresol novolac resin, and a hydroxybenzaldehyde phenolic novolac resin; and a polyfunctional compound, such as tetrahydroxydiphenylmethane, tetrahydroxybenzophenone, and polyvinylphenol. An alicyclic polyol obtained by hydrogenating the aromatic ring of any of these aromatic polyols can be reacted with epichlorohydrin to thereby obtain a glycidyl ether. Among these glycidyl ether of a polyol having an alicyclic ring, diglycidyl ether of hydrogenated bisphenol A is preferable.

Examples of the aliphatic epoxy compound include a polyglycidyl ether of an aliphatic polyhydric alcohol or an alkylene oxide adduct thereof. Specific examples include diglycidyl ether of 1,4-butanediol; diglycidyl ether of 1,6-hexanediol; triglycidyl ether of glycerin; triglycidyl ether of trimethylolpropane; diglycidyl ether of polyethylene glycol; diglycidyl ether of propylene glycol; diglycidyl ether of neopentyl glycol; and a polyglycidyl ether of polyether polyol obtained by adding one or more alkylene oxides (such as ethylene oxide and propylene oxide) to an aliphatic polyhydric alcohol such as ethylene glycol, propylene glycol or glycerin.

The alicyclic epoxy compound is a compound having at least one structure in which carbon atoms of an alicyclic ring also forms an oxirane ring, per molecule. "CELLOXIDE" series and "CYCLOMER" (all manufactured by DAICEL CORPORATION) and "CYRACURE UVR" series (manufactured by The Dow Chemical Company) can be used.

Examples of the vinyl ether compound include 2-hydroxyethyl vinyl ether, triethylene glycol vinyl monoether, tetraethylene glycol divinyl ether, and trimethylolpropane trivinyl ether.

The photopolymerizable compound preferably includes the polyfunctional (meth)acrylate monomer having three or more (meth)acryloyloxy groups per molecule (the compound (D-3)). When the composition includes the compound (D-3), the heat resistance and mechanical strength of the film can be larger, and furthermore, the compound (D-3) may be advantageous in terms of view of improvement in optical characteristics, including the emission intensity. In addition, when the composition include the compound (D-3), the composition may has improved curability.

Examples of the compound (D-3) include a compound having three or more (meth)acryloyloxy groups per molecule and having an acid functional group, (D-3a); and a compound having three or more (meth)acryloyloxy groups per molecule and having no acid functional group, (D-3b). The photopolymerizable compound preferably includes at least one of the compound (D-3a) and the compound (D-3b), and may include two or more compounds (D-3a), two or more compounds (D-3b), or at least one compound (D-3a) and at least one compound (D-3b). Examples of the acid functional group include a carboxy group, a sulfonic acid group, and a phosphoric acid group. The acid functional group is preferably a carboxy group among these.

The number of the (meth)acryloyloxy groups per molecule of the compound (D-3) is, for example, 3 or more and 6 or less, preferably 3 or more and 5 or less, more preferably 3. The number of the acid functional groups per molecule of the compound (D-3a) is, for example, 1 or more, preferably 1. In a case where the compound (D-3a) has two or more acid functional groups, the acid functional groups may be different or the same, and the compound (D-3a) preferably has at least one carboxy group.

Examples of the compound (D-3a) include a compound obtained by esterifying a dicarboxylic acid and a compound having three or more (meth)acryloyloxy groups and a hydroxy group, such as pentaerythritol tri(meth)acrylate or dipentaerythritol penta(meth)acrylate. Examples thereof include a monoester compound between pentaerythritol tri(meth)acrylate and succinic acid, a monoester compound between dipentaerythritol penta(meth)acrylate and succinic acid, a monoester compound between pentaerythritol tri(meth)acrylate and maleic acid, and a monoester compound between dipentaerythritol penta(meth)acrylate and maleic acid. Among these, preferred is the monoester compound between pentaerythritol tri(meth)acrylate and succinic acid.

Examples of commercially available products of the compound (D-3a) include "ARONIX M-510", which includes as the main component dibasic acid anhydride adduct of a pentaerythritol tri(meth)acrylate and is manufactured by TOAGOSEI CO., LTD., and "ARONIX M-520D", which include as the main component a dibasic acid anhydride adduct of dipentaerythritol penta(meth)acrylate and is manufactured by TOAGOSEI CO., LTD. These commercially available products have a carboxy group as the acid functional group.

The polymerizable compound (D) preferably includes: (Da) a polymerizable compound that can enhance the dispersibility of particles, and the polymerizable compound (D) is more preferably the polymerizable compound (Da). Examples of the polymerizable compound (Da) include a polymerizable compound having a polar group. The polar group is capable of adsorbing the first particle (A-1) and the second particle (A-2). Accordingly, the polymerizable compound (D) that includes the polymerizable compound (Da) is advantageous in terms of reducing the sedimentation velocity v represented by the formula (i). The polar group may be at least one group selected from the group consisting of a carboxy group (-COOH), a thiol group (-SH), and an amino group ($-NH_2$), and is preferably a carboxy group. The polymerizable compound (Da) may be two or more types of the polar group. Examples of the polymerizable compound (Da) include the compound (D-3a) described above.

When the photopolymerizable compound includes the compound (D-3), the content ratio of the compound (D-3) is preferably 5% by mass or more, more preferably 10% by mass or more, even more preferably 20% by mass or more, and may be 30% by mass or more, 50% by mass or more, 70% by mass or more, 90% by mass or more, or 100% by mass, based on the total amount of the photopolymerizable compound, in view enhancing curability of the composition, heat resistance of the film, and optical characteristics of the film, including the emission intensity.

When the photopolymerizable compound includes the compound (D-3), the content ratio of the compound (D-3) is preferably 0.5% by mass or more and 50% by mass or less, more preferably 1% by mass or more and 40% by mass or less, even more preferably 2% by mass or more and 30% by mass or less, still more preferably 2% by mass or more and 25% by mass or less, based on the total amount of the solids content of the composition, in view enhancing curability of the composition, heat resistance of the film, and optical characteristics of the film, including the emission intensity.

The photopolymerizable compound may include a (meth)acrylate monomer having a vinylether group and a (meth)acryloyl group (preferably (meth)acryloyloxy group) in the same molecule (hereinafter also referred to as "compound (D-4)"). The composition that contains the compound (D-4) may be advantageous in terms of improving optical characteristics of the film, such as the emission intensity. The compound (D-4) may be a compound that belongs to any one of the compounds (D-1) to (D-3).

The number of the vinylether groups of the compound (D-4) is preferably 1 or more and 4 or less, more preferably 1 or more and 2 or less, particularly preferably 1. The number of the (meth)acryloyl groups of the compound (D-4) is preferably 1 or more and 4 or less, more preferably 1 or more and 2 or less, particularly preferably 1.

Examples of the compound (D-4) include 2-vinyloxyethyl (meth)acrylate, 3-vinyloxypropyl (meth)acrylate, 2-vinyloxypropyl (meth)acrylate, 1-vinyloxypropyl (meth)acrylate, 1-methyl-2-vinyloxyethyl (meth)acrylate, 4-vinyloxybutyl (meth)acrylate, 3-vinyloxybutyl (meth)acrylate, 2-vinyloxybutyl (meth)acrylate, 1-methyl-3-vinyloxypropyl (meth)acrylate, 2-methyl-3-vinyloxypropyl (meth)acrylate, 1-methyl-2-vinyloxypropyl (meth)acrylate, 1,1-dimethyl-2-vinyloxyethyl (meth) acrylate, 6-vinyloxyhexyl (meth)acrylate, 4-vinyloxycyclohexyl (meth)acrylate, (4-vinyloxymethylcyclohexyl)methyl (meth)acrylate, (3-vinyloxymethylcyclohexyl)methyl (meth)acrylate, (2-vinyloxymethylcyclohexyl)methyl(meth)acrylate, (4-vinyloxymethylphenyl)methyl (meth)acrylate, (3-vinyloxymethylphenyl)methyl (meth)acrylate, 2-vinyloxymethylphenylmethyl (meth)acrylate, 2-(2-vinyloxyisopropoxy)ethyl (meth)acrylate, 2-(2-vinyloxyethoxy)ethyl (meth)acrylate, 2-(2-vinyloxyethoxy)propyl (meth)acrylate, 2-(2-vinyloxyisopropoxy)propyl (meth)acrylate, 2-(2-vinyloxyethoxy)isopropyl (meth)acrylate, 2-(2-vinyloxyisopropoxy)isopropyl (meth)acrylate, 2-{2-(2-vinyloxyethoxy)ethoxy}ethyl (meth)acrylate, 2-{2-(2-vinyloxyisopropoxy)ethoxy}ethyl (meth)acrylate, 2-{2-(2-vinyloxyisopropoxy)isopropoxy}ethyl (meth)acrylate, 2-{2-(2-vinyloxyethoxy)ethoxy}propyl (meth)acrylate, 2-{2-(2-vinyloxyethoxy)isopropoxy}propyl (meth)acrylate, 2-{2-(2-vinyloxyisopropoxy)ethoxy}propyl (meth)acrylate, 2-{2-(2-vinyloxyisopropoxy)isopropoxy}propyl (meth)acrylate, 2-{2-(2-vinyloxyethoxy)ethoxy}isopropyl (meth)acrylate, 2-{2-(2-vinyloxyethoxy)isopropoxy}isopropyl (meth)acrylate, 2-{2-(2-vinyloxyisopropoxy)ethoxy}isopropyl (meth)acrylate, 2-{2-(2-vinyloxyisopropoxy)isopropoxy}isopropyl (meth)acrylate, 2-[2-{2-(2-vinyloxyethoxy)ethoxy}ethoxy]ethyl (meth)acrylate, 2-[2-{2-(2-vinyloxyisopropoxy)ethoxy}ethoxy]ethyl (meth)acrylate, 2-(2-[2-{2-(2-vinyloxyethoxy)ethoxy}ethoxy]ethoxy)ethyl (meth)acrylate.

The compound (D-4) is preferably vinyloxy $C_{1-6}$alkyl (meth) acrylate or (vinyloxy $C_{1-4}$alkoxy) $C_{1-4}$alkyl(meth) acrylate, more preferably (vinyloxy $C_{1-4}$alkoxy)$C_{1-4}$alkyl(meth)acrylate, particularly preferably 2-(2-vinyloxyethoxy)ethyl

(meth)acrylate.

In a case where the photopolymerizable compound includes the compound (D-4), the content ratio of the compound (D-4) is preferably 5% by mass or more, more preferably 10% by mass or more, even more preferably 20% by mass or more, still more preferably 25% by mass or more, and preferably 85% by mass or less, more preferably 75% by mass or less, even more preferably 65% by mass or less, still more preferably 60% by mass or less, particularly preferably 55% by mass or less, based on the total amount of the photopolymerizable compound, in view of, for example, enhancing optical characteristics of the film, including the emission intensity.

In a case where the photopolymerizable compound includes the compound (D-4), the content ratio of the compound (D-4) is preferably 3% by mass or more and 50% by mass or less, more preferably 5% by mass or more and 45% by mass or less, even more preferably 10% by mass or more and 40% by mass or less, still more preferably 150 by mass or more and 35% by mass or less, based on the total amount of the solids content of the composition, in view of, for example, enhancing optical characteristics of the film, including the emission intensity.

In a case where the photopolymerizable compound includes the compound (D-1), the content ratio of the compound (D-1) is preferably 5% by mass or more, more preferably 10% by mass or more, even more preferably 150 by mass or more, still more preferably 20% by mass or more, particularly preferably 25% by mass or more, and preferably 75% by mass or less, more preferably 65% by mass or less, even more preferably 60% by mass or less, still more preferably 55% by mass or less, particularly preferably 50% by mass or less, based on the total amount of the photopolymerizable compound.

In a case where the photopolymerizable compound includes the compound (D-1), the content ratio of the compound (D-1) is preferably 5% by mass or more and 50% by mass or less, more preferably 8% by mass or more and 45% by mass or less, even more preferably 10% by mass or more and 40% by mass or less, still more preferably 150 by mass or more and 35% by mass or less, based on the total amount of the solids content of the composition.

In a case where the composition contains the polymerizable compound (D), the content ratio of the polymerizable compound (D) in the composition is preferably 0.5% by mass or more and 90% by mass or less, more preferably 1% by mass or more and 80% by mass or less, even more preferably 2% by mass or more and 75% by mass or less, still more preferably 2% by mass or more and 70% by mass or less, based on the total amount of the solids content of the composition.

[6] Polymerization initiator (E)

In a case where the composition contains the polymerizable compound (D), the composition preferably further contains a polymerization initiator (E). The polymerization initiator (E) is a compound that may generate, for example, an active radical or an acids by action of light or heat to initiate polymerization of the polymerizable compound (D). The composition can contain one or more types of the polymerization initiators (E).

Examples of the polymerization initiator (E) include a photopolymerization initiator, such as an oxime compound, an alkylphenone compound, a bimidazole compound, a triazine compound, and an acylphosphine compound, and a thermal polymerization initiator, such as an azo compound and an organic peroxide.

An example of the oxime compound is an oxime compound having the first molecular structure represented by the formula (1) below. This oxime compound will be hereinafter also referred to as "oxime compound (1)".

[Formula 7]

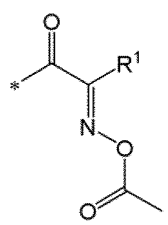

(1)

Including the oxime compound (1) as the polymerization initiator (E) is advantageous in terms of view of enhancing optical characteristics of the film, including the emission intensity. One reason for exhibiting such an effect is inferred as follows: due to the characteristic molecular structure of the oxime compound (1), the absorption wavelength of the oxime compound (1) significantly changes before and after cleavage (decomposition), which is necessary to initiate photopolymerization by the oxime compound (1), and the oxime compound (1) thus has the large capability of initiating radical photopolymerization.

In the formula (1), $R^1$ represents $R^{11}$, $OR^{11}$, $COR^{11}$, $SR^{11}$, $CONR^{12}R^{13}$, or CN.

$R^{11}$, $R^{12}$, and $R^{13}$ each independently represent a hydrogen atom, an alkyl group having 1 to 20 carbon atoms, an

aryl group having 6 to 30 carbon atoms, an aralkyl group having 7 to 30 carbon atoms, or a heterocyclic group having 2 to 20 carbon atoms.

A hydrogen atom of the group represented by $R^{11}$, $R^{12}$, or $R^{13}$ is optionally replaced by $OR^{21}$, $COR^{21}$, $SR^{21}$, $NR^{22}Ra^{23}$, $CONR^{22}R^{23}$, $-NR^{22}-OR^{23}$, $-N(COR^{22})-OCOR^{23}$, $-C(=N-OR^{21})-R^{22}$, - $C(=N-OCOR^{21})-R^{22}$, CN, a halogen atom, or $COOR^{21}$.

$R^{21}$, $R^{22}$, and $R^{23}$ each independently represent a hydrogen atom, an alkyl group having 1 to 20 carbon atoms, an aryl group having 6 to 30 carbon atoms, an aralkyl group having 7 to 30 carbon atoms, or a heterocyclic group having 2 to 20 carbon atoms.

A hydrogen atom of the group represented by $R^{21}$, $R^{22}$, or $R^{23}$ is optionally replaced by CN, a halogen atom, a hydroxy group, or a carboxy group.

In a case where the group represented by $R^{11}$, $R^{12}$, $R^{13}$, $R^{21}$, $R^{22}$, or $R^{23}$ has an alkylene moiety, the alkylene moiety may be interrupted 1 to 5 times by -O-, -S-, - COO-, -OCO-, $-NR^{24}-$, $-NR^{24}CO-$, $-NR^{24}COO-$, $-OCONR^{24}-$, -SCO-, -COS-, -OCS-, or -CSO-.

$R^{24}$ represents a hydrogen atom, an alkyl group having 1 to 20 carbon atoms, an aryl group having 6 to 30 carbon atoms, an aralkyl group having 7 to 30 carbon atoms, or a heterocyclic group having 2 to 20 carbon atoms.

In a case where the group represented by $R^{11}$, $R^{12}$, $R^{13}$, $R^{21}$, $R^{22}$, or $R^{23}$ has an alkyl moiety, the alkyl moiety may be branched or cyclic, and $R^{12}$ and $R^{13}$, or $R^{22}$ and $R^{23}$ may together form a ring.

**[0180]** * represent a bond to the second molecular structure, which is another molecular structure different from the first molecular structure of the oxime compound (1) .

Examples of the alkyl group having 1 to 20 carbon atoms represented by $R^{11}$, $R^{12}$, $R^{13}$, $R^{21}$, $R^{22}$, $R^{23}$, and $R^{24}$ in the formula (1) include a methyl group, an ethyl group, a propyl group, an isopropyl group, a butyl group, an isobutyl group, a sec-butyl group, a tert-butyl group, a pentyl group, an isopentyl group, a tert-pentyl group, a hexyl group, a heptyl group, an octyl group, an isooctyl group, a 2-ethylhexyl group, a tert-octyl group, a nonyl group, an isononyl group, a decyl group, an isodecyl group, an undecyl group, a dodecyl group, a tetradecyl group, a hexadecyl group, an octadecyl group, an icosyl group, a cyclopentyl group, a cyclohexyl group, a cyclohexylmethyl group, and a cyclohexylethyl group.

Examples of the aryl group having 6 to 30 carbon atoms represented by $R^{11}$, $R^{12}$, $R^{13}$, $R^{21}$, $R^{22}$, $R^{23}$, and $R^{24}$ in the formula (1) include a phenyl group, a tolyl group, a xylyl group, an ethylphenyl group, a naphthyl group, an anthryl group, a phenanthryl group, and a phenyl group, a biphenyl group, a naphthyl group, and an anthryl group substituted with one or more aforementioned alkyl groups.

Examples of the aralkyl group having 7 to 30 carbon atoms represented by $R^{11}$, $R^{12}$, $R^{13}$, $R^{21}$, $R^{22}$, $R^{23}$, and $R^{24}$ in the formula (1) include a benzyl group, an $\alpha$-methylbenzyl group, an $\alpha$, $\alpha$-dimethylbenzyl group, and a phenylethyl group.

Examples of the heterocyclic group having 2 to 20 carbon atoms represented by $R^{11}$, $R^{12}$, $R^{13}$, $R^{21}$, $R^{22}$, $R^{23}$, and $R^{24}$ in the formula (1) include a pyridyl group, a pyrimidyl group, a furyl group, a thienyl group, a tetrahydrofuryl group, a dioxolanyl group, a benzoxazol-2-yl group, a tetrahydropyranyl group, a pyrrolidyl group, an imidazolidyl group, a pyrazolidyl group, a thiazolidyl group, an isothiazolidyl group, an oxazolidyl group, an isoxazolidyl group, a piperidyl group, a piperazyl group, and a morpholinyl group, and the heterocyclic group is preferably a 5- to 7-membered heterocyclic ring.

For the formula (1), the phrase "$R^{12}$ and $R^{13}$, or $R^{22}$ and $R^{23}$ may together form a ring" means that $R^{12}$ and $R^{13}$, or $R^{22}$ and $R^{23}$, together with the nitrogen atom, carbon atom, or oxygen atom bonded thereto, may form a ring.

Examples of the ring that may be formed by $Ra^{12}$ and $Ra^{13}$, or $Ra^{22}$ and $Ra^{23}$, together in the formula (1) include a cyclopentane ring, a cyclohexane ring, a cyclopentene ring, a benzene ring, a piperidine ring, a morpholine ring, a lactone ring, and a lactam ring, and the ring is preferably a 5- to 7-membered ring.

Example of the halogen atom $R^{11}$, $R^{12}$, $R^{13}$, $R^{21}$, $R^{22}$, and $R^{23}$ in the formula (1) optionally has as a substituent include a fluorine atom, a chlorine atom, a bromine atom, and an iodine atom.

$R^1$ in the formula (1) is preferably $R^{11}$, more preferably an alkyl group having 1 to 20 carbon atoms, even more preferably an alkyl group having 1 to 10 carbon atoms, still more preferably an alkyl group having 1 to 6 carbon atoms.

One example of the second molecular structure bonded to the first molecular structure represented by the formula (1) is the structure represented by the formula (2). The second molecular structure is the molecular structure moiety other than the first molecular structure in the oxime compound (1).

The bond represented by "*" in the formula (2) is directly bonded to the bond represented by "*" in the formula (1). In other words, when the second molecular structure is the structure represented by the formula (2), the benzene ring having "-*" in the formula (2) is directly bonded to the carbonyl group having "-*" in the formula (1).

[Formula 8]

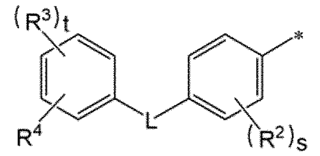

(2)

In the formula (2), $R^2$ and $R^3$ each independently represent $R^{11}$, $OR^{11}$, $SR^{11}$, $COR^{11}$, $CONR^{12}R^{13}$, $NR^{12}COR^{11}$, $OCOR^{11}$, $COOR^{11}$, $SCOR^{11}$, $OCSR^{11}$, $COSR^{11}$, $CSOR^{11}$, CN, or a halogen atom.

When a plurality of $R^2$ are present, they may be the same or different.

When a plurality of $R^3$ are present, they may be the same or different.

$R^{11}$, $R^{12}$, and $R^{13}$ each have the same meaning as above described.

s and t each independently represent an integer of 0 to 4.

L represents a sulfur atom, $CR^{31}R^{32}$, CO, or $NR^{33}$.

$R^{31}$, $R^{32}$, and $R^{33}$ each independently represent a hydrogen atom, an alkyl group having 1 to 20 carbon atoms, an aryl group having 6 to 30 carbon atoms, or an aralkyl group having 7 to 30 carbon atoms.

When the group represented by $R^{31}$, $R^{32}$, or $R^{33}$ has an alkyl moiety, the alkyl moiety may be branched or cyclic, and $R^{31}$, $R^{32}$, and $R^{33}$ may each independently, together with either adjacent benzene ring, form a ring.

$R^4$ represents a hydroxy group, a carboxy group, or a group represented by the following formula (2-1):

[Formula 9]

$$(R^{4a})_v\text{—}L^2\text{—}L^1\text{—} \qquad (2\text{-}1)$$

wherein $L^1$ represents -O-, -S-, $-NR^{22}-$, $-NR^{22}CO-$, $-SO_2-$, -CS-, -OCO-, or -COO-,
$R^{22}$ has the same meaning as above described,
$L^2$ represents a group formed by removing a number v of hydrogen atoms from an alkyl group having 1 to 20 carbon atoms, a group formed by removing a number v of hydrogen atoms from an aryl group having 6 to 30 carbon atoms, a group formed by removing a number v of hydrogen atoms from an aralkyl group having 7 to 30 carbon atoms, or a group formed by removing a number v of hydrogen atoms from a heterocyclic group having 2 to 20 carbon atoms,
when the group represented by $L^2$ has an alkylene moiety, the alkylene moiety may be interrupted 1 to 5 times by -O-, -S-, -COO-, -OCO-, $-NR^{22}-$, $-NR^{22}COO-$, $-OCONR^{22}-$, -SCO-, -COS-, -OCS-, or -CSO-, and the alkylene moiety may be branched or cyclic,
$R^{4a}$ represents $OR^{41}$, $SR^{41}$, $CONR^{42}R^{43}$, $NR^{42}COR^{43}$, $OCOR^{41}$, $COOR^{41}$, $SCOR^{41}$, $OCSR^{41}$, $COSR^{41}$, $CSOR^{41}$, CN, or a halogen atom,
when a plurality of $R^{4a}$ are present, they may be the same or different,
$R^{41}$, $R^{42}$, and $R^{43}$ each independently represent a hydrogen atom, an alkyl group having 1 to 20 carbon atoms, an aryl group having 6 to 30 carbon atoms, or an aralkyl group having 7 to 30 carbon atoms; when the group represented by $R^{41}$, $R^{42}$, or $R^{43}$ has an alkyl moiety, the alkyl moiety may be branched or cyclic, and $R^{42}$ and $R^{43}$ may together form a ring, and
v represents an integer of 1 to 3.

**[0200]** * represents a bond to the first molecular structure of the oxime compound (1).

For the alkyl group having 1 to 20 carbon atoms, the aryl group having 6 to 30 carbon atoms, or the aralkyl group having 7 to 30 carbon atoms represented by $R^{11}$, $R^{12}$, $R^{13}$, $R^{21}$, $R^{22}$, $R^{23}$, $R^{24}$, $R^{31}$, $R^{32}$ and $R^{33}$ in the formula (2), and $R^{22}$, $R^{41}$, $R^{42}$, and $R^{43}$ in the formula (2-1), examples thereof include those listed for $R^{11}$, $R^{12}$, $R^{13}$, $R^{21}$, $R^{22}$, $R^{23}$, and $R^{24}$ in the formula (1) .

For the heterocyclic group having 2 to 20 carbon atoms represented by $R^{11}$, $R^{12}$, $R^{13}$, $R^{21}$, $R^{22}$, $R^{23}$, and $R^{24}$ in the formula (2), and $R^{22}$ in the formula (2-1), examples thereof include those listed for $R^{11}$, $R^{12}$, $R^{13}$, $R^{21}$, $R^{22}$, $R^{23}$, and $R^{24}$ in the formula (1) .

For the formula (2), the phrase "$R^{31}$, $R^{32}$, and $R^{33}$ may each independently, together with either adjacent benzene ring, form a ring" means $R^{31}$, $R^{32}$, and $R^{33}$ each independently, together with either adjacent benzene ring and also with the nitrogen atom or the carbon atom bonded thereto, may form a ring.

Examples of the ring that may be formed by $R^{31}$, $R^{32}$, or $R^{33}$ together with either adjacent benzene ring in the formula (2) include those listed for the ring that may be formed by $Ra^{12}$ and $Ra^{13}$, or $Ra^{22}$ and $Ra^{23}$, together in the formula (1).

$L^2$ in the formula (2-1) represents a group formed by removing a number v of hydrogen atoms from an alkyl group having 1 to 20 carbon atoms, an aryl group having 6 to 30 carbon atoms, an aralkyl group having 7 to 30 carbon atoms, or a heterocyclic group having 2 to 20 carbon atoms.

Examples of the group formed by removing a number v of hydrogen atoms from an alkyl group having 1 to 20 carbon atoms when v is 1 include alkylene groups such as a methylene group, an ethylene group, a propylene group, a methylethylene group, a butylene group, a 1-methylpropylene group, a 2-methylpropylene group, a 1,2-dimethylpropylene group, a 1,3-dimethylpropylene group, a 1-methylbutylene group, a 2-methylbutylene group, a 3-methylbutylene group, a 4-methylbutylene group, a 2,4-dimethylbutylene group, a 1,3-dimethylbutylene group, a pentylene group, a hexylene group, a heptylene group, an octylene group, a nonylene group, a decylene group, a dodecylene group, a tridecylene group, a tetradecylene group, a pentadecylene group, an ethane-1,1-diyl group, and a propane-2,2-diyl group.

Examples of the group formed by removing a number v of hydrogen atoms from an aryl group having 6 to 30 carbon atoms when v is 1 include arylene groups such as a 1,2-phenylene group, a 1,3-phenylene group, a 1,4-phenylene group, a 2,6-naphthylene group, a 1,4-naphthylene group, a 2,5-dimethyl-1,4-phenylene group, an diphenylmethane-4,4'-diyl group, a 2,2-diphenylpropane-4,4'-diyl group, a diphenylsulfide-4,4'-diyl group, and diphenylsulfone-4,4'-diyl group.

Examples of the group formed by removing a number v of hydrogen atoms from an aralkyl group having 7 to 30 carbon atoms when v is 1 include a group represented by the following formula (a) and a group represented by the following formula (b).

[Formula 10]

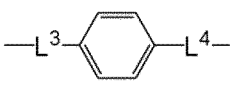
(a)

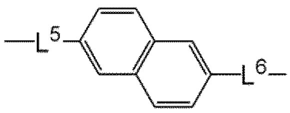
(b)

wherein $L^3$ and $L^5$ represent an alkylene group having 1 to 10 carbons, and $L^4$ and $L^6$ represent a single bond or an alkylene group with 1 to 10 carbons.

Examples of the alkylene group having 1 to 10 carbons include a methylene group, an ethylene group, a propylene group, a methyl ethylene group, a butylene group, a 1-methyl propylene group, a 2-methyl propylene group, a 1,2-dimethyl propylene group, a 1,3-dimethylpropylene group, a 1-methylbutylene group, a 2-methylbutylene group, a 3-methylbutylene group, a 4-methylbutylene group, a 2,4-dimethylbutylene group, a 1,3-dimethylbutylene group, a pentylene group, a hexylene group, a heptylene group, an octylene group, a nonylene group, and a decylene group.

Examples of the group formed by removing a number v of hydrogen atoms from a heterocyclic group having 2 to 20 carbon atoms when v is 1 include divalent heterocyclic groups such as a 2,5-pyridinediyl group, a 2,6-pyridinediyl group, a 2,5-pyrimidinediyl group, a 2,5-thiophenediyl group, a 3,4-tetrahydrofurandiyl group, a 2,5-tetrahydrofurandiyl group, a 2,5-furandiyl group, a 3,4-thiazolidiyl group, a 2,5-benzofuranediyl group, a 2,5-benzothiophenediyl group, an N-methylindole-2,5-diyl group, a 2,5-benzothiazoldiyl group, and a 2,5-benzoxazoldiyl group.

Examples of the halogen atom represented by $R^2$ or $R^3$ in the formula (2) and $R^{4a}$ in the formula (2-1) include a fluorine atom, a chlorine atom, a bromine atom, and an iodine atom.

A preferable example of the structure represented by the formula (2) is a structure represented by the formula (2a) below, in view of solubility in a solvent (H) and developability of the composition.

[Formula 11]

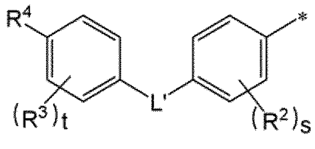
(2a)

wherein L' represents a sulfur atom or $NR^{50}$, and $R^{50}$ represents a linear, branched, or cyclic alkyl group having 1 to 20 carbon atoms, and $R^2$, $R^3$, $R^4$, s, and t have the same meaning as described above.

From the same viewpoint, another preferable example of the structure represented by the formula (2) is a structure represented by the following formula (2b):

[Formula 12]

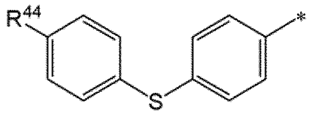

(2b)

wherein $R^{44}$ represents a hydroxy group, a carboxy group, or a group represented by the following formula (2-2) :

[Formula 13]

$R^{44a}—L^{12}—L^{11}—$ (2-2)

wherein $L^{11}$ represents -O- or *-OCO-, * represents the bond to $L^{12}$, $L^{12}$ represents an alkylene group having 1 to 20 carbons, the alkylene group may be interrupted 1 to 3 times by -O-, $R^{44a}$ represents $OR^{55}$ or $COOR^{55}$, and $R^{55}$ represents a hydrogen atom or an alkyl group having 1 to 6 carbons.

$R^{44}$ is preferably a group represented by the formula (2-2). This is advantageous in terms of solubility of the oxime compound (1) in a solvent (H) and developability of the composition.

The alkylene group represented by $L^{12}$ preferably has 1 to 10 carbon atoms, more preferably 1 to 4 carbon atoms.

$R^{44a}$ is preferably a hydroxy group or a carboxy group, more preferably a hydroxy group.

The method for producing the oxime compound (1) having the second molecular structure represented by the formula (2) is not particularly limited, and such an oxime compound can be produced by a method described in JP 2011-132215A, for example.

Another example of the second molecular structure bonded to the first molecular structure represented by the formula (1) is a structure represented by the formula (3) below.

The bond represented by "*" in the formula (3) is directly bonded to the bond represented by "*" in the formula (1). In other words, when the second molecular structure is the structure represented by the formula (3), the benzene ring having "-*" in the formula (3) is directly bonded to the carbonyl group having "-*" in the formula (1).

[Formula 14]

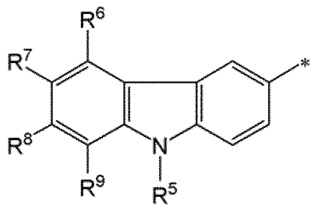

(3)

In the formula (3), $R^5$ represents a hydrogen atom, an alkyl group having 1 to 20 carbon atoms, an aryl group having 6 to 30 carbon atoms, an arylalkyl group having 7 to 30 carbon atoms, or a heterocyclic group having 2 to 20 carbon atoms.

When the group represented by $R^5$ has an alkyl moiety, the alkyl moiety may be branched or cyclic.

A hydrogen atom of the group represented by $R^5$ is optionally replaced by $R^{21}$, $OR^{21}$, $COR^{21}$, $SR^{21}$, $NR^{22}R^{23}$, $CONR^{22}R^{23}$, $-NR^{22}-OR^{23}$, $-N(COR^{22})-OCOR^{23}$, $NR^{22}COR^{21}$, $OCOR^{21}$, $COOR^{21}$, $-C(=N-OR^{21})-R^{22}$, $-C(=N-OCOR^{21})-R^{22}$, $SCOR^{21}$, $OCSR^{21}$, $COSR^{21}$, $CSOR^{21}$, a hydroxy group, a nitro group, CN, a halogen atom, or $COOR^{21}$.

$R^{21}$, $R^{22}$, and $R^{23}$ has the same meaning as described above.

A hydrogen atom of the group represented by $R^{21}$, $R^{22}$, or $R^{23}$ is optionally replaced by CN, a halogen atom, a hydroxy group, or a carboxy group.

When the group represented by $R^{21}$, $R^{22}$, or $R^{23}$ has an alkylene moiety, the alkylene moiety may be interrupted 1 to 5 times by -O-, -S-, -COO-, -OCO-, $-NR^{24}-$, $-NR^{24}CO-$, $-NR^{24}COO-$, $-OCONR^{24}-$, -SCO-, -COS-, -OCS-, or -CSO-.

$R^{24}$ has the same meaning as described above.

When the group represented by $R^{21}$, $R^{22}$, or $R^{23}$ has an alkyl moiety, the alkyl moiety may be branched or cyclic, and $R^{22}$ and $R^{23}$ may together form a ring.

$R^6$, $R^7$, $R^8$, and $R^9$ each independently represent $R^{61}$, $OR^{61}$, $SR^{61}$, $COR^{62}$, $CONR^{63}R^{64}$, $NR^{65}COR^{61}$, $OCOR^{61}$, $COOR^{62}$, $SCOR^{61}$, $OCSR^{61}$, $COSR^{62}$, $CSOR^{61}$, a hydroxy group, a nitro group, CN, or a halogen atom.

$R^{61}$, $R^{62}$, $R^{63}$, $R^{64}$, and $R^{65}$ each independently represent a hydrogen atom, an alkyl group having 1 to 20 carbon atoms, an aryl group having 6 to 30 carbon atoms, an arylalkyl group having 7 to 30 carbon atoms, or a heterocyclic group

having 2 to 20 carbon atoms.

A hydrogen atom of the group represented by $R^{61}$, $R^{62}$, $R^{63}$, $R^{64}$, or $R^{65}$ is optionally replaced by $OR^{21}$, $COR^{21}$, $SR^{21}$, $NR^{22}Ra^{23}$, $CONR^{22}R^{23}$, $-NR^{22}-OR^{23}$, $-N(COR^{22})-OCOR^{23}$, $-C(=N-OR^{21})-R^{22}$, $-C(=N-OCOR^{21})-R^{22}$, CN, a halogen atom, or $COOR^{21}$.

$R^6$ and $R^7$; $R^7$ and $R^8$; and $R^8$ and $R^9$ each may together form a ring.

**[0232]** * represents a bond to the first molecular structure of the oxime compound (1).

For the alkyl group having 1 to 20 carbon atoms, the aryl group having 6 to 30 carbon atoms, the aralkyl group having 7 to 30 carbon atoms, and the heterocyclic group having 2 to 20 carbon atoms represented by $R^5$, $R^{21}$, $R^{22}$, $R^{23}$, $R^{24}$, $R^{61}$, $R^{62}$, $R^{63}$, $R^{64}$ or $R^{65}$ in the formula (3), examples thereof include those listed for $R^{11}$, $R^{12}$, $R^{13}$, $R^{21}$, $R^{22}$, $R^{23}$, and $R^{24}$ in the formula (1) .

For the formula (3), the phrase "$R^{22}$ and $R^{23}$ may together form a ring" means that $R^{22}$ and $R^{23}$, together with the nitrogen atom, the carbon atom, or the oxygen atom bonded thereto, may form a ring.

Examples of the ring that may be formed by $R^{22}$ and $R^{23}$ together include those listed for the ring that may be formed by $Ra^{12}$ and $Ra^{13}$, or $Ra^{22}$ and $Ra^{23}$ together in the formula (1).

Examples of the halogen atom represented by $R^6$, $R^7$, $R^8$, or $R^9$ and the halogen atom that may replace a hydrogen atom of $R^5$, $R^{21}$, $R^{22}$, $R^{23}$, $R^{61}$, $R^{62}$, $R^{63}$, $R^{64}$, or $R^{65}$ in the formula (3) include a fluorine atom, a chlorine atom, a bromine atom, and an iodine atom.

In a preferable embodiment, $R^5$ is a group represented by the formula (3-1) in view of solubility in a solvent (H) and developability of the composition.

[Formula 15]

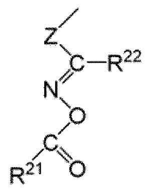

(3-1)

wherein Z represents a group formed by removing one hydrogen atom from an alkyl group having 1 to 20 carbon atoms, a group formed by removing one hydrogen atom from an aryl group having 6 to 30 carbon atoms, a group formed by removing one hydrogen atom from an aralkyl group having 7 to 30 carbon atoms, or a group formed by removing one hydrogen atom from a heterocyclic group having 2 to 20 carbon atoms,

when the group represented by Z has an alkylene moiety, the alkylene moiety may be interrupted 1 to 5 times by -O-, -S-, -COO-, -OCO-, $-NR^{24}-$, $-NR^{24}COO-$, $-OCONR^{24}-$, -SCO-, -COS-, -OCS-, or -CSO-, and the alkylene moiety may be branched or cyclic, and

$R^{21}$, $R^{22}$, and $R^{24}$ have the same meaning as described above.

From the same viewpoint, Z in the formula (3-1) is preferably a methylene group, an ethylene group, or a phenylene group.

From the same viewpoint, $R^{21}$ and $R^{22}$ in the formula (3-1) is preferably an alkyl group having 1 to 20 carbons or an aryl group having 6 to 30 carbons, and more preferably a methyl group, an ethyl group, or a phenyl group.

In another preferable embodiment, $R^7$ is preferably a nitro group from the same viewpoint.

The method for producing the oxime compound (1) having the second molecular structure represented by the formula (3) is not particularly limited, and such an oxime compound can be produced by a method described in JP 2000-80068A or JP 2011-178776A, for example.

Still another example of the second molecular structure bonded to the first molecular structure represented by the formula (1) is a structure represented by the formula (4) below.

The bond represented by "*" in the formula (4) is directly bonded to the bond represented by "*" in the formula (1). In other words, when the second molecular structure is the structure represented by the formula (4), the benzene ring having "-*" in the formula (4) is directly bonded to the carbonyl group having "-*" in the formula (1).

[Formula 16]

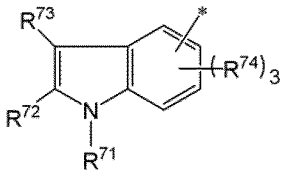

(4)

In the formula (4), $R^{71}$ represents a hydrogen atom, an alkyl group having 1 to 20 carbon atoms, an aryl group having 6 to 30 carbon atoms, an aralkyl group having 7 to 30 carbon atoms, or a heterocyclic group having 2 to 20 carbon atoms.

When the group represented by $R^{71}$ has an alkyl moiety, the alkyl moiety may be branched or may be cyclic.

A hydrogen atom of the group represented by $R^{71}$ is optionally replaced by $R^{21}$, $OR^{21}$, $COR^{21}$, $SR^{21}$, $NR^{22}R^{23}$, $CONR^{22}R^{23}$, $-NR^{22}-OR^{23}$, $-N(COR^{22})-OCOR^{23}$, $NR^{22}COR^{21}$, $OCOR^{21}$, $COOR^{21}$, $-C(=N-OR^{21})-R^{22}$, $-C(=N-OCOR^{21})-R^{22}$, $SCOR^{21}$, $OCSR^{21}$, $COSR^{21}$, $CSOR^{21}$, a hydroxy group, a nitro group, CN, a halogen atom, or $COOR^{21}$.

$R^{21}$, $R^{22}$, and $R^{23}$ has the same meaning as described above.

A hydrogen atom of the group represented by $R^{21}$, $R^{22}$, or $R^{23}$ is optionally replaced by CN, a halogen atom, a hydroxy group, or a carboxy group.

When the group represented by $R^{21}$, $R^{22}$, or $R^{23}$ has an alkylene moiety, the alkylene moiety may be interrupted 1 to 5 times by -O-, -S-, -COO-, -OCO-, $-NR^{24}-$, $-NR^{24}CO-$, - $NR^{24}COO-$, $-OCONR^{24}-$, -SCO-, -COS-, -OCS-, or -CSO-.

$R^{24}$ has the same meaning as described above.

When the group represented by $R^{21}$, $R^{22}$, or $R^{23}$ has an alkyl moiety, the alkyl moiety may be branched or cyclic, and $R^{22}$ and $R^{23}$ may together form a ring.

$R^{72}$, $R^{73}$, and three $R^{74}$ each independently represent $R^{61}$, $OR^{61}$, $SR^{61}$, $COR^{62}$, $CONR^{63}R^{64}$, $NR^{65}COR^{61}$, $OCOR^{61}$, $COOR^{62}$, $SCOR^{61}$, $OCSR^{61}$, $COSR^{62}$, $CSOR^{61}$, a hydroxy group, a nitro group, CN, or a halogen atom.

$R^{61}$, $R^{62}$, $R^{63}$, $R^{64}$, and $R^{65}$ each independently represent a hydrogen atom, an alkyl group having 1 to 20 carbon atoms, an aryl group having 6 to 30 carbon atoms, an arylalkyl group having 7 to 30 carbon atoms, or a heterocyclic group having 2 to 20 carbon atoms.

A hydrogen atom of the group represented by $R^{61}$, $R^{62}$, $R^{63}$, $R^{64}$, or $R^{65}$ is optionally replaced by $OR^{21}$, $COR^{21}$, $SR^{21}$, $NR^{22}Ra^{23}$, $CONR^{22}R^{23}$, $-NR^{22}-OR^{23}$, $-N\ (COR^{22})-OCOR^{23}$, $-C(=N-OR^{21})-R^{22}$, $-C\ (=N-OCOR^{21})-R^{22}$, CN, a halogen atom, or $COOR^{21}$.

$R^{72}$ and $R^{73}$; and two $R^{74}$ each may together form a ring.

**[0256]** * represents a bond to the first molecular structure of the oxime compound (1).

For the alkyl group having 1 to 20 carbon atoms, the aryl group having 6 to 30 carbon atoms, the aralkyl group having 7 to 30 carbon atoms, and the heterocyclic group having 2 to 20 carbon atoms represented by $R^{71}$, $R^{21}$, $R^{22}$, $R^{23}$, $R^{24}$, $R^{61}$, $R^{62}$, $R^{63}$, $R^{64}$ or $R^{65}$ in the formula (4), examples thereof include those listed for $R^{11}$, $R^{12}$, $R^{13}$, $R^{21}$, $R^{22}$, $R^{23}$, and $R^{24}$ in the formula (1) .

For the formula (4), the phrase "$R^{22}$ and $R^{23}$ may together form a ring" means that $R^{22}$ and $R^{23}$, together with the nitrogen atom, the carbon atom, or the oxygen atom bonded thereto, may form a ring.

Examples of the ring that may be formed by $R^{22}$ and $R^{23}$ together include those listed for the ring that may be formed by $Ra^{12}$ and $Ra^{13}$, or $Ra^{22}$ and $Ra^{23}$ together in the formula (1).

Examples of the halogen atom represented by $R^{72}$, $R^{73}$ or $R^{74}$ in the formula (4) and the halogen atom that may replace a hydrogen atom of $R^{71}$, $R^{21}$, $R^{22}$, $R^{23}$, $R^{61}$, $R^{62}$, $R^{63}$, $R^{64}$, or $R^{65}$ include a fluorine atom, a chlorine atom, a bromine atom, and an iodine atom.

The method for producing the oxime compound (1) having the second molecular structure represented by the formula (4) is not particularly limited, and such an oxime compound can be produced by a method described in WO 2017/051680A or WO 2020/004601A, for example.

Still another example of the second molecular structure bonded to the first molecular structure represented by the formula (1) is a structure represented by the formula (5) below.

The bond represented by "*" in the formula (5) is directly bonded to the bond represented by "*" in the formula (1). In other words, when the second molecular structure is the structure represented by the formula (5), the pyrrole ring having "-*" in the formula (5) is directly bonded to the carbonyl group having "-*" in the formula (1).

[Formula 17]

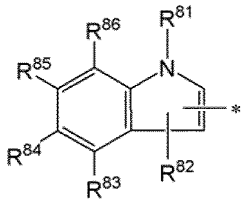

(5)

In the formula (5), $R^{81}$ represents a hydrogen atom, an alkyl group having 1 to 20 carbon atoms, an aryl group having 6 to 30 carbon atoms, an aralkyl group having 7 to 30 carbon atoms, or a heterocyclic group having 2 to 20 carbon atoms.
When the group represented by $R^{81}$ has an alkyl moiety, the alkyl moiety may be branched or may be cyclic.
A hydrogen atom of the group represented by $R^{81}$ is optionally replaced by $R^{21}$, $OR^{21}$, $COR^{21}$, $SR^{21}$, $NR^{22}R^{23}$, $CONR^{22}R^{23}$, $-NR^{22}-OR^{23}$, $-N(COR^{22})-OCOR^{23}$, $NR^{22}COR^{21}$, $OCOR^{21}$, $COOR^{21}$, $-C(=N-OR^{21})-R^{22}$, $-C(=N-OCOR^{21})-R^{22}$, $SCOR^{21}$, $OCSR^{21}$, $COSR^{21}$, $CSOR^{21}$, a hydroxy group, a nitro group, CN, a halogen atom, or $COOR^{21}$.
$R^{21}$, $R^{22}$, and $R^{23}$ each have the same meaning as described above.
A hydrogen atom of the group represented by $R^{21}$, $R^{22}$, or $R^{23}$ is optionally replaced by CN, a halogen atom, a hydroxy group, or a carboxy group.
When the group represented by $R^{21}$, $R^{22}$, or $R^{23}$ has an alkylene moiety, the alkylene moiety may be interrupted by 1 to 5 times by -O-, -S-, -COO-, -OCO-, $-NR^{24}-$, $-NR^{24}CO-$, $-NR^{24}COO-$, $-OCONR^{24}-$, -SCO-, -COS-, -OCS-, or - CSO-.
$R^{24}$ has the same meaning as described above.
When the group represented by $R^{21}$, $R^{22}$, or $R^{23}$ has an alkyl moiety, the alkyl moiety may be branched or cyclic, and $R^{22}$ and $R^{23}$ may together form a ring.
$R^{82}$, $R^{83}$, $R^{84}$, $R^{85}$, and $R^{86}$ each independently represent $R^{61}$, $OR^{61}$, $SR^{61}$, $COR^{62}$, $CONR^{63}R^{64}$, $NR^{65}COR^{61}$, $OCOR^{61}$, $COOR^{62}$, $SCOR^{61}$, $OCSR^{61}$, $COSR^{62}$, $CSOR^{61}$, a hydroxy group, a nitro group, CN, or a halogen atom.
$R^{61}$, $R^{62}$, $R^{63}$, $R^{64}$, and $R^{65}$ each independently represent a hydrogen atom, an alkyl group having 1 to 20 carbon atoms, an aryl group having 6 to 30 carbon atoms, an arylalkyl group having 7 to 30 carbon atoms, or a heterocyclic group having 2 to 20 carbon atoms.
A hydrogen atom of the group represented by $R^{61}$, $R^{62}$, $R^{63}$, $R^{64}$, or $R^{65}$ is optionally replaced by $OR^{21}$, $COR^{21}$, $SR^{21}$, $NR^{22}Ra^{23}$, $CONR^{22}R^{23}$, $-NR^{22}-OR^{23}$, $-N(COR^{22})-OCOR^{23}$, $-C(=N-OR^{21})-R^{22}$, $-C(=N-OCOR^{21})-R^{22}$, CN, a halogen atom, or $COOR^{21}$.
$R^{83}$ and $R^{84}$; $R^{84}$ and $R^{85}$; and $R^{85}$ and $R^{86}$ each may together form a ring.
**[0276]** * represents a bond to the first molecular structure of the oxime compound (1).
For the alkyl group having 1 to 20 carbon atoms, the aryl group having 6 to 30 carbon atoms, the aralkyl group having 7 to 30 carbon atoms, and the heterocyclic group having 2 to 20 carbon atoms represented by $R^{81}$, $R^{21}$, $R^{22}$, $R^{23}$, $R^{24}$, $R^{61}$, $R^{62}$, $R^{63}$, $R^{64}$ or $R^{65}$ in the formula (5), examples thereof include those listed for $R^{11}$, $R^{12}$, $R^{13}$, $R^{21}$, $R^{22}$, $R^{23}$, and $R^{24}$ in the formula (1) .
For the formula (5), the phrase "$R^{22}$ and $R^{23}$ may together form a ring" means that $R^{22}$ and $R^{23}$, together with the nitrogen atom, the carbon atom, or the oxygen atom bonded thereto, may form a ring.
Examples of the ring that may be formed by $R^{22}$ and $R^{23}$ together include those listed for the ring that may be formed by $Ra^{12}$ and $Ra^{13}$, or $Ra^{22}$ and $Ra^{23}$ together in the formula (1).
Examples of the halogen atom represented by $R^{82}$, $R^{83}$, $R^{84}$, $R^{85}$, or $R^{86}$ in the formula (5) and the halogen atom that may replace a hydrogen atom of $R^{81}$, $R^{21}$, $R^{22}$, $R^{23}$, $R^{61}$, $R^{62}$, $R^{63}$, $R^{64}$, or $R^{65}$ include a fluorine atom, a chlorine atom, a bromine atom, and an iodine atom.
The method for producing the oxime compound (1) having the second molecular structure represented by the formula (5) is not particularly limited, and such an oxime compound can be produced by a method described in WO 2017/051680A or WO 2020/004601A, for example.
Still another example of the second molecular structure bonded to the first molecular structure represented by the formula (1) is a structure represented by the formula (6) below.
The bond represented by "*" in the formula (6) is directly bonded to the bond represented by "*" in the formula (1). In other words, when the second molecular structure is the structure represented by the formula (6), the benzene ring having "-*" in the formula (6) is directly bonded to the carbonyl group having "-*" in the formula (1).

[Formula 18]

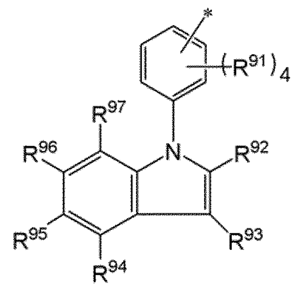

(6)

In the formula (6), a number 4 of $R^{91}$, and $R^{92}$, $R^{93}$, $R^{94}$, $R^{95}$, $R^{96}$, and $R^{97}$ each independently represent $R^{61}$, $OR^{61}$, $SR^{61}$, $COR^{62}$, $CONR^{63}R^{64}$, $NR^{65}COR^{61}$, $OCOR^{61}$, $COOR^{62}$, $SCOR^{61}$, $OCSR^{61}$, $COSR^{62}$, $CSOR^{61}$, a hydroxy group, a nitro group, CN, or a halogen atom.

$R^{61}$, $R^{62}$, $R^{63}$, $R^{64}$, and $R^{65}$ each independently represent a hydrogen atom, an alkyl group having 1 to 20 carbon atoms, an aryl group having 6 to 30 carbon atoms, an aralkyl group having 7 to 30 carbon atoms, or a heterocyclic group having 2 to 20 carbon atoms.

A hydrogen atom of the group represented by $R^{61}$, $R^{62}$, $R^{63}$, $R^{64}$, or $R^{65}$ is optionally replaced by $OR^{21}$, $COR^{21}$, $SR^{21}$, $NR^{22}Ra^{23}$, $CONR^{22}R^{23}$, $-NR^{22}-OR^{23}$, $-N(COR^{22})-OCOR^{23}$, $-C(=N-OR^{21})-R^{22}$, $-C(=N-OCOR^{21})-R^{22}$, CN, a halogen atom, or $COOR^{21}$.

$R^{21}$, $R^{22}$, and $R^{23}$ each have the same meaning as described above.

$R^{92}$ and $R^{93}$; $R^{94}$ and $R^{95}$; $R^{95}$ and $R^{96}$; and $R^{96}$ and $R^{97}$ each may together form a ring.

**[0289]** * represents a bond to the first molecular structure of the oxime compound (1).

For the alkyl group having 1 to 20 carbon atoms, the aryl group having 6 to 30 carbon atoms, the aralkyl group having 7 to 30 carbon atoms, and the heterocyclic group having 2 to 20 carbon atoms represented by $R^{21}$, $R^{22}$, $R^{23}$, $R^{61}$, $R^{62}$, $R^{63}$, $R^{64}$, or $R^{65}$ in the formula (6), examples thereof include those listed for $R^{11}$, $R^{12}$, $R^{13}$, $R^{21}$, $R^{22}$, and $R^{23}$ in the formula (1) .

For the formula (6), the phrase "$R^{22}$ and $R^{23}$ may together form a ring" means that $R^{22}$ and $R^{23}$, together with the nitrogen atom, the carbon atom, or the oxygen atom bonded thereto, may form a ring.

Examples of the ring that may be formed by $R^{22}$ and $R^{23}$ together include those listed for the ring that may be formed by $Ra^{12}$ and $Ra^{13}$, or $Ra^{22}$ and $Ra^{23}$ together in the formula (1).

Examples of the halogen atom represented by $R^{91}$, $R^{92}$, $R^{93}$, $R^{94}$, $R^{95}$, $R^{96}$, or $R^{97}$ in the formula (6) and the halogen atom that may replace a hydrogen atom of $R^{21}$, $R^{22}$, $R^{23}$, $R^{61}$, $R^{62}$, $R^{63}$, $R^{64}$, or $R^{65}$ include a fluorine atom, a chlorine atom, a bromine atom, and an iodine atom.

The method for producing the oxime compound (1) having the second molecular structure represented by the formula (6) is not particularly limited, and such an oxime compound can be produced by a method described in WO 2017/051680A or WO 2020/004601A, for example.

Other examples of the photopolymerization initiator include other photopolymerization initiators than the oxime compound (1). Examples of the other photopolymerization initiators include an oxime compound other than the oxime compound (1), an alkylphenone compound, a bimidazole compound, a triazine compound, and an acylphosphine compound.

Examples of an oxime compound other than the oxime compound (1) include an oxime compound having a partial structure represented by the following formula (d1). * represents a bond.

[Formula 19]

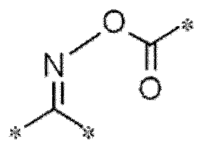

(d1)

Examples of the oxime compound having a partial structure represented by the formula (d1) include N-benzoyloxy-1-(4-phenylsulfanylphenyl)butan-1-one-2-imine, N-benzoyloxy-1-(4-phenylsulfanylphenyl)octan-1-one-2-imine, N-benzoyloxy-1-(4-phenylsulfanylphenyl)-3-cyclopentylpropan-1-one-2-imine, N-acetoxy-1-[9-ethyl-6-(2-methylbenzoyl)-9H-carbazole-3-yl]ethane-1-imine, N-acetoxy-1-[9-ethyl-6-{2-methyl-4-(3,3-dimethyl-2,4-dioxacyclopentanylmethyloxy)benzoyl}-9H-carbazole-3-yl]ethane-1-imine, N-acetoxy-1-[9-ethyl-6-(2-methylbenzoyl)-9H-carbazole-3-yl]-3-cyclopentylpropane-1-imine, and N-benzoyloxy-1-[9-ethyl-6-(2-methylbenzoyl)-9H-carbazole-3-yl]-3-cyclopentylpropan-1-one-2-imine, and compounds disclosed in Japanese Patent Laid-Open No. 2011-132215, International Publication No. 2008/78678, International Publication No. 2008/78686, and International Publication No. 2012/132558. Commercially available products may be used, including Irgacure (registered trademark) OXE01, OXE02, and OXE03 (all manufactured by BASF SE), and N-1919, NCI-930, and NCI-831 (all manufactured by ADEKA CORPORATION).

Among others, the oxime compound having a partial structure represented by the formula (d1) is preferably at least one selected from the group consisting of N-benzoyloxy-1-(4-phenylsulfanylphenyl)butan-1-one-2-imine, N-benzoyloxy-1-(4-phenylsulfanylphenyl)octan-1-one-2-imine, and N-benzoyloxy-1-(4-phenylsulfanylphenyl)-3-cyclopentylpropan-1-one-2-imine, and is more preferably N-benzoyloxy-1-(4-phenylsulfanylphenyl)octan-1-one-2-imine.

The alkylphenone compound is a compound having a partial structure represented by the following formula (d2) or a partial structure represented by the following formula (d3). In these partial structures, the benzene ring may have a substituent.

[Formula 20]

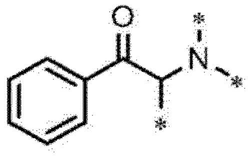

(d2)

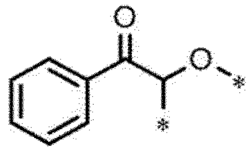

(d3)

Examples of the compound having a structure represented by the formula (d2) include 2-methyl-2-morpholino-1-(4-methylsulfanylphenyl)propan-1-one, 2-dimethylamino-1-(4-morpholinophenyl)-2-benzylbutan-1-one, and 2-(dimethylamino)-2-[(4-methylphenyl)methyl]-1-[4-(4-morpholinyl)phenyl]butan-1-one. Commercially available products may be used, including OMNIRAD (registered trademark) 369, 907, and 379 (all manufactured by IGM Resins B.V.).

Examples of the compound having a structure represented by the formula (d3) include 2-hydroxy-2-methyl-1-phenylpropan-1-one, 2-hydroxy-2-methyl-1-[4-(2-hydroxyethoxy)phenyl]propan-1-one, 1-hydroxycyclohexylphenyl ketone, an oligomer of 2-hydroxy-2-methyl-1-(4-isopropenylphenyl)propan-1-one, $\alpha,\alpha$-diethoxyacetophenone, and benzyl dimethyl ketal.

In view of sensitivity, the compound having a structure represented by the formula (d2) is preferable as the alkylphenone compound.

Examples of the biimidazole compound include a compound represented by the formula (d5):

[Formula 21]

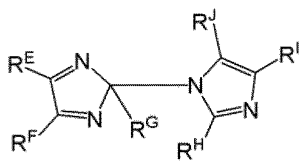

(d5)

[In the formula (d5), $R^E$ to $R^J$ represent an aryl group having 6 to 10 carbon atoms which may have a substituent.]

Examples of the aryl group having 6 to 10 carbon atoms include a phenyl group, a toluyl group, a xylyl group, an ethylphenyl group, and a naphthyl group, and a phenyl group is preferable.

Examples of the substituent include a halogen atom and an alkoxy group having 1 to 4 carbon atoms. Examples of the halogen atom include a fluorine atom, a chlorine atom, a bromine atom, and an iodine atom, and a chlorine atom is preferable. Examples of the alkoxy group having 1 to 4 carbon atoms include a methoxy group, an ethoxy group, a propoxy group, and a butoxy group, and a methoxy group is preferable.

Examples of the biimidazole compound include 2,2'-bis(2-chlorophenyl)-4,4',5,5'-tetraphenylbiimidazole, 2,2'-bis(2,3-dichlorophenyl)-4,4',5,5'-tetraphenylbiimidazole (for example, see Japanese Patent Laid-Open No. 06-75372 and Japanese Patent Laid-Open No. 06-75373), 2,2'-bis(2-chlorophenyl)-4,4',5,5'-tetraphenyl biimidazole, 2,2'-bis(2-chlorophenyl)-4,4',5,5'-tetra(alkoxyphenyl)biimidazole, 2,2'-bis(2-chlorophenyl)-4,4',5,5'-tetra(dialkoxyphenyl)biimidazole, 2,2'-bis(2-chlorophenyl)-4,4',5,5'-tetra(trialkoxyphenyl)biimidazole (for example, see Japanese Patent No. 48-38403 and Japanese Patent Laid-Open No. 62-174204), and an imidazole compound in which phenyl groups at the 4,4',5,5' positions are each substituted with a carboalkoxy group (for example, see Japanese Patent Laid-Open No. 7-10913). Among others, the compounds represented by the following formulas and a mixture thereof are preferable.

[Formula 22]

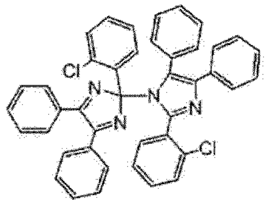
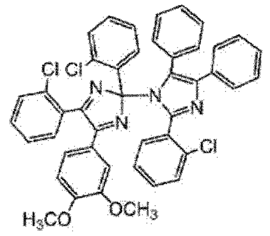
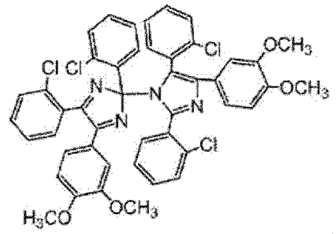

Examples of the triazine compound include 2,4-bis(trichloromethyl)-6-(4-methoxyphenyl)-1,3,5-triazine, 2,4-bis(trichloromethyl)-6-(4-methoxynaphthyl)-1,3,5-triazine, 2,4-bis(trichloromethyl)-6-piperonyl-1,3,5-triazine, 2,4-bis(trichloromethyl)-6-(4-methoxystyryl)-1,3,5-triazine, 2,4-bis(trichloromethyl)-6-[2-(5-methylfuran-2-yl)ethenyl]-1,3,5-triazine, 2,4-bis(trichloromethyl)-6-[2-(furan-2-yl)ethenyl]-1,3,5-triazine, 2,4-bis(trichloromethyl)-6-[2-(4-diethylamino-2-methylphenyl)ethenyl]-1,3,5-triazine, and 2,4-bis(trichloromethyl)-6-[2-(3,4-dimethoxyphenyl)ethenyl]-1,3,5-triazine. Among these, 2,4-bis(trichloromethyl)-6-piperonyl-1,3,5-triazine is preferable.

Examples of the acylphosphine compound include bis(2,4,6-trimethylbenzoyl)phenylphosphine oxide, and (2,4,6-trimethylbenzoyl)diphenylphosphine oxide. Commercially available products may be used, including OMNIRAD (registered trademark) 819 (manufactured by IGM Resins B.V.).

Other examples of the other photopolymerization initiators than the oxime compound (1) include a benzoin compound, such as benzoin, benzoin methyl ether, benzoin ethyl ether, benzoin isopropyl ether, and benzoin isobutyl ether; a benzophenone compound, such as benzophenone, methyl o-benzoyl benzoate, 4-phenylbenzophenone, 4-benzoyl-4'-methyldiphenyl sulfide, 3,3',4,4'-tetra(tert-butylperoxycarbonyl)benzophenone, 2,4,6-trimethylbenzophenone, and 4,4'-bis(diethylamino)benzophenone; a quinone compound, such as 9,10-phenanthrenequinone, 2-ethylanthraquinone, and camphorquinone; 10-butyl-2-chloroacridone, benzyl, methyl phenylglyoxylate, and a titanocene compound.

In a case where the composition contains the polymerization initiator (E), the content ratio of the polymerization initiator (E) in the composition is, for example, 0.01% by mass or more and 20% by mass or less, based on the total amount of the solids content of the composition, and from the viewpoint of enhancing the sensitivity of the composition and enhancing the emission intensity and heat resistance of the film, it is preferably 0.1% by mass or more and 15% by mass or less, more preferably 0.15% by mass or more and 10% by mass or less, even more preferably 0.2% by mass or more and 8% by mass or less, and may be 5% by mass or less, or 3% by mass or less.

[7] Antioxidant (F)

The composition may contain an antioxidant (F). The antioxidant (F) is not particularly limited as long as it is an antioxidant for general industrial use, and a phenolic antioxidant, a phosphorus antioxidant, a phosphorus/phenolic composite antioxidant, or a sulfur antioxidant can be used, for example. Two or more types of the antioxidant (F) may be used in combination.

The phosphorus/phenolic composite antioxidant can be a compound having one or more phosphorus atoms and one or more phenolic structures per molecule. In view of the optical characteristics of the film, including the emission intensity, the antioxidant (F) preferably includes the phosphorus/phenolic composite antioxidant.

Examples of the phenol-based antioxidant include Irganox (R) 1010 (Irganox 1010: pentaerythritol tetrakis [3-(3,5-di-tert-butyl-4-hydroxyphenyl)propionate], manufactured by BASF Japan Ltd.), Irganox 1076 (Irganox 1076: Octadecyl-3-(3,5-di-tert-butyl-4-hydroxyphenyl)propionate, manufactured by BASF Japan Ltd.), Irganox 1330 (Irganox 1330: 3,3',3'',5,5',5''-hexa-tert-butyl-a,a',a''-(mesitylene-2,4,6-triyl)tri-p-cresol, BASF Japan Ltd.), Irganox 3114 (Irganox 3114: 1,3,5-tris(3,5-di-tert-butyl-4-hydroxybenzyl)-1,3,5-triazine-2,4,6(1H,3H,5H)-trione, BASF Japan Ltd.), Irganox 3790 (Irganox 3790: 1,3,5-tris((4-tert-butyl-3-hydroxy-2,6-xylyl)methyl)-1,3,5-triazine-2,4,6(1H,3H,5H)-trione, BASF Japan Ltd.), Irganox 1035 (Irganox 1035: thiodiethylenebis[3-(3,5-di-tert-butyl-4 hydroxyphenyl)propionate], manufactured by BASF Japan Ltd.), Irganox 1135 (Irganox 1135: 3,5-bis(1,1-dimethylethyl)-4-hydroxy-C7-C9 side-chain alkyl ester of benzene propanoic acid, manufactured by BASF Japan Ltd.), Irganox 1520 L (Irganox 1520 L: 4,6-bis(octylthiomethyl)-o-cresol, manufactured by BASF Japan Ltd.), Irganox 3125 (Irganox 3125, BASF Japan Ltd.), Irganox 565 (Irganox 565: 2,4-bis(n-octylthio)-6-(4-hydroxy-3',5'-di-tert-butylanilino)-1,3,5-triazine, manufactured by BASF Japan Ltd.), ADK STAB (R) AO-80 (ADK STAB AO-80: 3,9-bis(2-(3-(3-tert-butyl-4-hydroxy-5-methylphenyl)propionyloxy)-1,1-dimethylethyl)-2,4,8,10-tetraoxaspiro(5,5)undecane, manufactured by ADEKA Corporation), SUMILIZER (R) BHT, SUMILIZER GA-80, SUMILIZER GS (manufactured by Sumitomo Chemical Co., Ltd.), Cyanox (R) 1790 (Cyanox 1790, manufactured by Cytec Industries Inc.), and vitamin E (manufactured by Eisai Co., Ltd.).

Examples of the phosphorus antioxidant include Irgafos (registered trademark) 168 (tris(2,4-di-tert-butylphenyl) phosphite, manufactured by BASF SE), Irgafos (registered trademark) 12 (tris[2-[[2,4,8,10-tetra-tert-butyl dibenzo[d,f][1,3,2]dioxaphosphin-6-yl]oxy]ethyl]amine, manufactured by BASF SE), Irgafos (registered trademark) 38 (bis(2,4-bis(1,1-dimethylethyl)-6-methylphenyl) ethyl phosphite, manufactured by BASF SE), ADEKASTAB (registered trademark) 329K, PEP36, and PEP-8 (all manufactured by ADEKA CORPORATION), Sandstab P-EPQ (manufactured by CLARIANT), Weston (registered trademark) 618 and 619G (manufactured by GE), and Ultranox 626 (manufactured by GE) .

Examples of the phosphorus/phenolic composite antioxidant include SUMILIZER (R) GP (6-[3-(3-tert-butyl-4-hydroxy-5-methylphenyl)propoxy]-2,4,8,10-tetra-tert-butyl dibenz[d,f][1.3.2]dioxaphosphepine) (manufactured by Sumitomo Chemical Co., Ltd.).

Examples of the sulfur-based antioxidant include dialkyl thiodipropionate compounds such as dilauryl thiodipropionate, dimyristyl thiodipropionate, and distearate thiodipropionate; and β-alkylmercaptopropionic acid ester compounds of polyols such as tetrakis[methylene(3-dodecylthio)propionate]methane.

In a case where the composition contains the antioxidant (F), the content ratio of the antioxidant (F) in the composition is, for example, 0.1% by mass or more and 20% by mass or less, preferably 0.5% by mass or more and 15% by mass or less, more preferably 1% by mass or more and 10% by mass or less, even more preferably 1% by mass or more and 5% by mass or less, based on the total amount of the solids content of the composition.

[8] Solvent (H)

The composition may contain a solvent (H). Examples of the solvent (H) include an ester solvent (a solvent having -COO- but no -O- in its molecule), an ether solvent (a solvent having -O- but no -COO- in its molecule), an ether ester solvent (a solvent having -COO- and -O- in its molecule), a ketone solvent (a solvent having -CO- but no -COO- in its molecule), an alcohol solvent (a solvent having OH but no -O-, -CO-, or -COO-), an aromatic hydrocarbon solvent, an amide solvent, and dimethyl sulfoxide. These may be used in combinations of two or more thereof as the solvent (H).

Examples of the ester solvent include methyl lactate, ethyl lactate, n-butyl lactate, methyl 2-hydroxyisobutanoate, ethyl acetate, n-butyl acetate, isobutyl acetate, n-pentyl formate, isopentyl acetate, n-butyl propionate, isopropyl butyrate, ethyl butyrate, n-butyl butyrate, methyl pyruvate, ethyl pyruvate, propyl pyruvate, methyl acetoacetate, ethyl acetoacetate, cyclohexanol acetate, and γ-butyrolactone.

Examples of the ether solvent include ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol monobutyl ether, propylene glycol monomethyl ether, propylene glycol monoethyl ether, propylene glycol monopropyl ether, propylene glycol monobutyl ether, 3-methoxy-1-butanol, 3-methoxy-3-methylbutanol, tetrahydrofuran, tetrahydropyran, 1,4-dioxane, diethylene glycol dimethyl ether, diethylene glycol diethyl ether, diethylene glycol methyl ethyl ether, diethylene glycol dipropyl ether, diethylene glycol dibutyl ether, anisole, phenetol, and methyl anisole.

Examples of the ether ester solvent include methyl methoxyacetate, ethyl methoxyacetate, butyl methoxyacetate, methyl ethoxyacetate, ethyl ethoxyacetate, methyl 3-methoxypropionate, ethyl 3-methoxypropionate, methyl 3-ethoxypropionate, ethyl 3-ethoxypropionate, methyl 2-methoxypropionate, ethyl 2-methoxypropionate, propyl 2-methoxypropionate, methyl 2-ethoxypropionate, ethyl 2-ethoxypropionate, methyl 2-methoxy-2-methylpropionate, ethyl 2-ethoxy-2-methylpropionate, 3-methoxybutylacetate, 3-methyl-3-methoxybutyl acetate, propylene glycol monomethyl ether acetate, propylene glycol monoethyl ether acetate, propylene glycol monopropyl ether acetate, ethylene glycol monomethyl ether acetate, ethylene glycol monoethyl ether acetate, diethylene glycol monoethyl ether acetate, and diethylene glycol monobutyl ether acetate.

Examples of the ketone solvent include 4-hydroxy-4-methyl-2-pentanone, acetone, 2-butanone, 2-heptanone, 3-heptanone, 4-heptanone, 4-methyl-2-pentanone, cyclopentanone, cyclohexanone, and isophorone.

Examples of the alcohol solvent include methanol, ethanol, propanol, butanol, hexanol, cyclohexanol, ethylene glycol, propylene glycol, and glycerin. Examples of the aromatic hydrocarbon solvent include benzene, toluene, xylene, and mesitylene. Examples of the amide solvent include N,N-dimethylformamide, N,N-dimethylacetamide, and N-methylpyrrolidone.

The solvent (H) is preferably propylene glycol monomethyl ether acetate, ethyl lactate, propylene glycol monomethyl ether, ethyl 3-ethoxypropionate, ethylene glycol monomethyl ether, diethylene glycol monomethyl ether, diethylene glycol monoethyl ether, 4-hydroxy-4-methyl-2-pentanone, or toluene, or a mixture of two or more thereof.

[9] Other components

The composition may further contain additives known in the art, such as a polymerization inhibitor, a filler, another polymer compound, an adhesion promoter, a light stabilizer, a chain transfer agent, a polymerization initiation aid, and a

leveling agent, if necessary

[10] Sedimentation velocity v of composition

The composition has a sedimentation velocity v represented by a formula (i) of $400 \times 10^{-9}$ cm/s or less. [Expression 2]

$$v = \frac{g(\rho_s - \rho)d^2}{18\mu} \qquad \text{(i)}$$

The formula (i) represents Stokes' law. In the formula, g is the gravitational acceleration, i.e., 980.665 $cm/s^2$. $\rho_s$ is the density [$g/cm^3$] of the first particle (A-1), $\rho$ is the density [$g/cm^3$] of a reference composition that has the same configuration as that of the composition disclosed herein, except that it does not contain particles (the first particle or the second particle), which is contained in the composition disclosed herein, (hereinafter also simply referred to as "fluid") and this density is hereinafter also referred to as "fluid density". $\mu$ is the viscosity [g/(cm.s)] of the composition at 25°C. The unit of the average particle diameter of the first particle (A-1), d, is cm. In a case where the composition contains two or more types of the first particle (A-1) different in the average particle diameter, the sedimentation velocity v represented by a formula (i) is preferably $400 \times 10^{-9}$ cm/s or less for each of the two or more types of the first particle (A-1), in view of forming a film exhibiting the characteristics of these particles well.

When the composition has a sedimentation velocity v of $400 \times 10^{-9}$ cm/s or less, a film exhibiting the characteristics of the first particles (A-1) well can be formed though the composition contains the first particles (A-1), of which average particle diameter d is relatively large. At least a part of the reason for this is that the first particle (A-1) is unlikely to settle in the composition. According to the present invention, variation in characteristics (such as the optical characteristics) is small, when a film prepared from the composition immediately after preparation is compared to that from the composition left to stand for 10 days after preparation, for example, and both the film can be excellent in the characteristics.

In a case where the composition further contains the light-emissive particle as the second particle (A-2), a sedimentation velocity v represented by the formula (i) of $400 \times 10^{-9}$ cm/s or less can improve the emission intensity of a film formed from the composition.

The sedimentation velocity v of the composition is preferably $300 \times 10^{-9}$ cm/s or less, more preferably $250 \times 10^{-9}$ cm/s or less, even more preferably $200 \times 10^{-9}$ cm/s or less, still more preferably $150 \times 10^{-9}$ cm/s or less, particularly preferably $100 \times 10^{-9}$ cm/s or less, most preferably $70 \times 10^{-9}$ cm/s or less. The sedimentation velocity v is generally $1 \times 10^{-9}$ cm/s or more, preferably $5 \times 10^{-9}$ cm/s or more, more preferably $10 \times 10^{-9}$ cm/s or more.

The sedimentation velocity v of the composition can be controlled by adjusting the average particle diameter d and he density $\rho_s$ of the first particle (A-1), and the solids content (solvent content) and the viscosity of the composition, for example.

The viscosity $\mu$ of the composition at 25°C is, for example, 0.1 g/(cm·s) or more and 300 g/(cm·s) or less, preferably 0.2 g/(cm·s) or more and 300 g/(cm·s) or less, more preferably 0.35 g/(cm·s) or more and 250 g/(cm·s) or less, even more preferably 0.5 g/(cm·s) or more and 200 g/(cm·s) or less, still more preferably 1 g/(cm·s) or more and 150 g/(cm·s) or less, particularly preferably 4 g/(cm·s) or more and 100 g/(cm·s) or less. The viscosity $\mu$ of the composition can be measured using a Brookfield rotational viscometer.

The density $\rho_s$ and the average particle diameter d of the first particle (A-1) may be measured before preparation of the composition, or the first particle (A-1) may be taken out from the composition and subjected to measurement. The same also applied to the average particle of the second particle (A-2), and also the fluid density $\rho$. For example, a particle can be separated from the composition by, for example centrifugal separation, and subjected to measurement of the physical properties of the particle (the density $\rho_s$ and the average particle diameter d of the first particle (A-1) and the average particle diameter of the second particle (A-2)). At this time, the dispersant and others adsorbed to the separated particle may be regarded as a part of the particle to measure the physical properties of the particle. The remainder after the separation of the particle can be regarded as the fluid to measure the fluid density $\rho$.

When the particles are separated from the composition before carrying out the measurement, the composition may contain the first particle (A-1) and the second particle (A-2) in some cases. In such a case, if the first particle (A-1) and the second particle (A-2) can be individually separated by, for example, centrifugal separation, they can be individually separated by such technique to measure the density or the average particle diameter of each particle. Alternatively, another method for measuring the average particle diameter of each particle is as follows for a case where the composition contains the first particle (A-1) and the second particle (A-2): a mixture of the first particle (A-1) and the second particle (A-2) are taken out from the composition; the particle size distribution of the mixture is determined and separated into the particle

size distribution of the first particle (A-1) and that of the second particle (A-2); and thus the average particle diameter of each particle is determined.

<Method for producing composition>

The composition can be produced by a method including the step of mixing the predetermined components and other components used as needed. The method for producing the composition can further include the step of preparing the resin (C).

The composition according to the first embodiment (hereinafter also referred to as "composition M") contains the first particle (A-1) and the resin (C). The composition M may be a composition that contains the first particle (A-1), the dispersant (B), and the resin (C). The composition M may further contain the polymerizable compound (D), and in that case, the composition M preferably further contains the polymerization initiator (E). The composition M preferably contains the solvent (H) in view of obtaining the good applicability of the composition and favorable flatness of the composition layer when applied.

In a case where the composition M contains the polymerizable compound (D), the content ratio of the polymerizable compound (D) in the composition M is, for example, 0.5% by mass or more and 50% by mass or less, preferably 1% by mass or more and 40% by mass or less, more preferably 2% by mass or more and 30% by mass or less, even more preferably 2% by mass or more and 25% by mass or less, based on the total amount of the solids content of the composition M.

The content ratio of the solvent (H) in the composition M is, for example, 40% by mass or more and 95% by mass or less, preferably 45% by mass or more and 90% by mass or less, more preferably 50% by mass or more and 80% by mass or less, based on the total amount of the composition M. In other words, the solids content concentration of the composition is, for example, 5% by mass or more and 60% by mass or less, preferably 10% by mass or more and 55% by mass or less, more preferably 20% by mass or more and 50% by mass or less. Among others, the solids content concentration of the composition is preferably 30% by mass or more, more preferably 34% by mass or more, even more preferably 36% by mass or more. The solids content concentration within such a range is advantageous in terms of suppression of generation of pinholes in the film.

The composition according to the second embodiment (hereinafter also referred to as "composition N") contains no resin (C). The composition N contains the first particle (A-1) and the polymerizable compound (D), and preferably further contains the polymerization initiator (E). The composition N may be a composition that contains the first particle (A-1), the dispersant (B), and the polymerizable compound (D). The composition N may contain the solvent (H), but it is preferable that the composition N should contain no solvent (H) or have a smaller content ratio thereof.

The content ratio of the polymerizable compound (D) in the composition N is, for example, 10% by mass or more and 90% by mass or less, preferably 20% by mass or more and 80% by mass or less, more preferably 30% by mass or more and 75% by mass or less, even more preferably 40% by mass or more and 70% by mass or less, still more preferably 50% by mass or more and 70% by mass or less, based on the total amount of the solids content of the composition.

The content ratio of the solvent (H) in the composition N is preferably 10% by mass or less, more preferably 5% by mass or less, even more preferably 3% by mass or less, still more preferably 2% by mass or less, particularly preferably 1% by mass or less, based on the total amount of the composition N, and may be 0% by mass, or 0.5% by mass or more. A smaller content of the solvent (H) makes the control of the film thickness easy in the formation of a cured film and can also reduce the production costs and loads of the solvent to global environment and working environment. The composition N can be suitably used as an ink for inkjet printer for preparing a film.

<Resin film and production method thereof>

The film according to the present invention is a film formed from the composition according to the present invention described hereinabove. The method for producing a film includes the following steps, for example:

the step of forming a composition layer by applying the composition to a substrate or by ejecting the composition into a region defined by a bank formed on a substrate; and
the step of heat-treating the composition layer.

The film may be formed on the whole surface of the substrate or may be formed in a part of the surface of the substrate (for example, in a pattern).

The method for producing a film may include other steps in addition to the above-described steps. Examples of the other steps include the exposure step of irradiating the composition layer with light, and the step of developing the composition layer after the exposure step.

For the step of forming a composition layer, examples of the method for applying the composition to a substrate

include spin coating, slit coating, and slit and spin coating. The step of forming a composition layer by ejecting the composition may be the step of ejecting the composition into selectively a region defined by a bank by, for example, inkjet printing to thereby adhere the composition to the region. The patterned composition layer may be formed by stencil printing, screen printing, or application printing with an applicator.

Examples of the substrate include a plate of glass such as silica glass, borosilicate glass, alumina silicate glass, and soda-lime glass having a silica-coated surface; a plate of resin such as polycarbonate, polymethyl methacrylate, and polyethylene terephthalate; silicon; and those obtained by forming a thin film of aluminum, silver, or silver/copper/palladium alloy on any of these substrates.

The patterned film can be formed on the substrate in the following manner, for example. First, a patterned composition layer is formed by applying the composition to a substrate via a mask or by ejecting the composition into a region defined by a bank.

Next, the composition layer is heat-treated to obtain a film. The heat-treatment may include drying the composition layer (removing volatile components, such a solvent). Examples of the drying method include drying by heat, drying under reduced pressure and combination thereof. The temperature when drying by heat is preferably 30°C or more and 120°C or less, more preferably 50°C or more and 110°C or less. The heating time is preferably 10 seconds or more and 60 minutes or less, more preferably 30 seconds or more and 30 minutes or less. In a case of where drying is carried out under reduced pressure, the pressure is preferably 50 Pa or more and 150 Pa or less. The drying of the composition layer may be carried out in a plural stages, and for example, drying is carried out a plural times at different drying temperatures.

The step of heat-treating the composition layer may include the above-described drying (pre-baking) and post-baking carried thereafter. The heating temperature of the baking is preferably 150°C or more and 250°C or less, more preferably 160°C or more and 235°C or less. The heating time is preferably 1 minute or more and 120 minutes or less, more preferably 10 minutes or more and 60 minutes or less.

In a case where the composition is curable (the composition contains the polymerizable compound (D) and preferably further the polymerization initiator (E)), the method for producing a film preferably includes the exposure step mentioned above. In a method involving use of photolithography, which is an example, a patterned cured film formed from a photocurable composition can be formed on a substrate in the following manner, for example. First, a composition layer is formed on a substrate, followed by drying, specifically, drying by heating (pre-baking) and/or drying under reduced pressure. The method for forming the composition layer and the method for drying it may be those described above.

Next, the composition layer is exposed to light via a photomask for forming the intended pattern. A light source used for exposure is preferably a light source generating light having a wavelength of 250 nm or more and 450 nm or less. For example, from light having a wavelength within the above-described range, light having a wavelength of about 436 nm, about 408 nm, or about 365 nm may be selectively extracted with a band pass filter according to the wavelength of light absorbed by the photopolymerization initiator. Specific examples of the light source include a mercury lamps, a light emitting diode, a metal halide lamp, and a halogen lamp.

An exposure device, such as a mask aligner and a stepper, is preferably used, whereby the whole surface to be exposed can be uniformly irradiated with parallel rays, or which enables precise positioning of the photomask and the substrate having the composition layer formed thereon. The composition layer exposed to light is cured thorough polymerization of the photopolymerizable compound and the like included in the composition layer.

The composition layer after the exposure to light can be brought into contact with a liquid developer to carry out the above-described developing step, whereby the unexposed part of the composition layer is dissolved in the liquid developer to be removed, and thus, a patterned cured film can be obtained. Examples of the liquid developer include an aqueous solution of an alkaline compound, such as potassium hydroxide, sodium bicarbonate, sodium carbonate, and tetramethylammonium hydroxide, and an organic solvent. The alkaline compound strength of the aqueous solution is preferably 0.01% by mass or more and 10% by mass or less, more preferably 0.03% by mass or more and 5% by mass or less. Examples of the organic solvent include those listed above as the solvent (H). The liquid developer may contain a surfactant.

The method for developing may be a paddle method, a dipping method, or a spray method. The substrate may be tilted at an arbitral angle during developing.

The patterned film obtained by the development is preferably further subjecting to heating (post-baking). The heating temperature is preferably 150°C or more and 250°C or less, more preferably 160°C or more and 235°C or less. The heating time is preferably 1 minute or more and 120 minutes or less, more preferably 10 minutes or more and 60 minutes or less. By heating after the development, polymerization of the unreacted photopolymerizable compound and the like contained in the film can proceed, so that a cured film highly excellent in chemical resistance can be obtained. In a case where the development is not carried out, the composition layer exposed to light is preferably further subjected to heating (post-baking).

On the other hand, the method for forming a film on the whole surface of a substrate may be a method including forming a composition layer on a substrate, drying the composition layer if needed, and heating the composition layer

and/or exposing the whole surface of the composition layer with light.

The thickness of the film is not particularly limited and may be selected as appropriate according to the purpose. The thickness is, for example, 1 μm or more and 30 μm or less, preferably 3 μm or more and 25 μm or less, more preferably 5 μm or more and 25 μm or less, even more preferably 5 μm or more and 20 μm or less. The shape and size of the patterned resin film are not particularly limited. The patterned resin film has a rectangular shape in the planer view, for example.

<Display device>

The display device according to the present invention includes at least a light source and the film described above. Examples of the display device include a liquid crystal display, an organic EL display, or an inorganic EL display. Specific examples includes display devices disclosed in Japanese Patent Laid-Open No. 2006-309219, Japanese Patent Laid-Open No. 2006-310303, Japanese Patent Laid-Open No. 2013-15812, Japanese Patent Laid-Open No. 2009-251129, and Japanese Patent Laid-Open No. 2014-2363.

The display device according to one embodiment includes a blue-light source as a back light and a plurality of patterns provided on the viewing side of the back light. The plurality of patterns may be a red pattern, a green pattern, and a white (transparent, achromatic) pattern, and at least one of these patterns may be the film according to the present invention. Each of the red pattern and the green pattern, which is a chromatic pattern, may be a film that has function to convert the wavelength of the incident light and emit light and that is formed from the composition containing the first particle (A-1) and the second particle (A-2). The white (transparent, achromatic) pattern may be a film that is formed from the composition containing the first particle (A-1) but not containing the second particle (A-2) .

Examples

The present invention will be described below in more detail by way of Examples. In Examples, "%" and "parts" means "% by mass" and "parts by mass" unless otherwise noticed.

<Determination and Evaluation>

(1) Determination of average particle diameter d of first particle (A-1)

The particle size distribution of titanium oxide ($TiO_2$) particle as the first particle (A-1) was determined on a sample for determination, a dispersion of the particle in propylene glycol monomethyl ether acetate (PGMEA) as a medium, using a centrifugal sedimentary analyzer for dispersion stability/particle size distribution under the following conditions, and the volume-weighted median diameter (D50) was obtained as the average particle diameter d [cm].

Analyzer: LUMiSizer 611, manufactured by LUM GmbH
Number of revolutions: 1000 rpm
Setup density: titanium oxide 4.260 g/cm$^3$, PGMEA 0.9700 g/cm$^3$
Setup refraction index: titanium oxide 2.720, PGMEA 1.400

(2) Determination of average particle diameter of second particle (A-2)

For a sample for determination, specifically, a dispersion of quantum dots as the second particle (A-2) in PGMEA as a medium, images of the particles were acquired using the scanning transmission electron microscope under the conditions described below. The images were binarized using image processing software "ImagePro", and from the resulting images, the particle diameter was calculated for 600 particles. The median thereof was obtained as the average particle diameter [cm] of the quantum dots as the second particle (A-2).

Analyzer: HeliosG4UX, manufactured by FEI
Mode: STEM BF mode
Acceleration voltage: 23 kV
Current: 50 pA

(3) Determination of density $\rho_s$ of first particle (A-1)

The density $\rho_s$ [g/cm$^3$] of the first particle (A-1) was determined in an environment at 25°C using a Gay-Lussac pycnometer.

(4) Determination of fluid density ρ

The density ρ [g/cm$^3$] of a fluid was determined in an environment at 25°C using a Gay-Lussac pycnometer. The fluid here means a composition that has the same configuration as that of the composition prepared in Example or Comparative Example, except that it does not contain particles (the first particle or the second particle).

(5) Determination of viscosity μ of composition (25°C)

The viscosity [g/(cm.s)] of the composition prepared in Example or Comparative Example was determined using a Brookfield rotational viscometer under the conditions of a constant temperature of 25°C and a number of rotation of 3 rpm.

(6) Sedimentation velocity v of composition

The sedimentation velocity v [cm/s] was calculated using the formula (i) described hereinabove.

(7) Weight average molecular weight Mw and number-average molecular weight Mn of resin (C)

The weight average molecular weight Mw and the number-average molecular weight Mn of the resin (C) were determined by GPC method under the following conditions.

System: K2479 (manufactured by Shimadzu Corporation)
Column: SHIMADZU Shim-pack GPC-80M
Column temperature: 40°C
Medium: tetrahydrofuran
Flow rate: 1.0 mL/min
Detector: RI
Standard substances for calibration: TSK STANDARD POLYSTYRENE F-40, F-4, F-288, A-2500, A-500 (manufactured by TOSOH CORPORATION)

(8) Acid value of resin (C)

3 g of a solution of the resin (C) was weighed precisely, and dissolved in a mixed solvent of 90 g of acetone and 10 g of water. On the resultant, the acid value of the solution of the resin (C) was determined using an automated titrator (product name "COM-555", manufactured by HIRANUMA Co., Ltd.) with a 0.1 N aqueous KOH solution as a titrant. From the acid value of the solution and the solids content of the solution, the acid value Av per 1 g of solids content [mg KOH/g] was determined.

(9) Solids content of solution of resin (C)

About 1 g of a solution of the resin (C) was weighed into an aluminum cup and dried at 180°C for 1 hour, and then, the mass thereof was measured. From the mass loss, the solids content [% by mass] of the solution of the resin (C) was determined.

(10) Evaluation of change of emission intensity

A light-scattering plate was placed on a backlight with a blue LED lamp having a wavelength of the emission peak of 450 nm as a point light source, and the resultant was used as a backlight member. The backlight member was placed with the light-scattering plate facing upward, and a spectral radiance meter ("SR-UL1R" manufactured by TOPCON TECHNOHOUSE CORPORATION) was arranged at a position 60 cm above the surface of the light-scattering plate.

Next, a substrate having a film prepared from the composition immediately after preparation, S1, was arranged on the surface of the above-described glass substrate. In that state, the backlight was turned on, and for the light emitted from the film, the cumulative radiant flux in the wavelength range of 485 nm or more and 780 nm or less was determined as the emission intensity E1 [$W \cdot sr^{-1} \cdot m^{-2} \cdot nm^{-1}$]. For the determination of the emission intensity E1, the spectral radiance meter ("SR-UL1R" manufactured by TOPCON TECHNOHOUSE CORPORATION) was used.

For a film prepared from the composition that had been left to stand at a temperature of 25°C for 10 days after preparation, S2, the emission intensity E2 [$W \cdot sr^{-1} \cdot m^{-2} \cdot nm^{-1}$] was also determined in the same manner as above.

From the above results, the change in the emission intensity, X, below was determined.

Change X [%] = 100 × Emission intensity E2/ Emission intensity E1

<Production Example 1: Preparation of dispersion of first particle (A1a)>

To 70 parts of a titanium oxide particle (average particle diameter d: 219 × $10^{-7}$ cm, density $\rho_s$: 4.260 g/$cm^3$) as the first particle (A1a) were added 3 parts, in terms of the solids content, of "DISPERBYK21116" (manufactured by BYK Japan KK) as a dispersant (B1) and PGMEA in an amount such that the total amount became 100 parts, and the resulting mixture was then stirred by using a paint shaker to achieve sufficient dispersing, to thereby obtain a dispersion of first particle (A1a) (solids content 73%).

<Production Example 2: Preparation of dispersion of first particle (A1b)>

A dispersion of the first particle (A1b) (solids content 73%) was obtained in the same manner as in Production Example 1, except that a titanium oxide particle (average particle diameter d: 192 × $10^{-7}$ cm, density $\rho_s$: 4.260 g/$cm^3$) as the first particle (A1b) was used instead of the first particle (A1a).

<Production Example 3: Preparation of dispersion of second particle (A2a)>

A dispersion of the second particle (A2a) in toluene was provided. The second particle (A2a) was InP/ZnSeS quantum dots with coordinating oleic acid as an organic ligand (G1) (average particle diameter: 6.0 × $10^{-7}$ cm). The dispersion in toluene was subjected to distillation under reduced pressure to remove toluene. To 50 parts of the solids content, 50 parts of cyclohexyl acetate was added to obtain a dispersion of second particle (A2a) (solids content 50%).

<Production Example 4: Preparation of dispersion of second particle (A2b)>

A dispersion of the second particle (A2b) (solids content 50%) was obtained in the same manner as in Production Example 3, except that InP/ZnSeS quantum dots with coordinating oleic acid as an organic ligand (G1) (average particle diameter: 4.6 × $10^{-7}$ cm) as the second particle (A2b) was used instead of the second particle (A2a).

<Production Example 5: Preparation of solution of resin (C1)>

To a flask equipped with a stirrer, a reflux cooling tube with a thermometer, a dropping funnel, and a nitrogen-introducing tube, 110 parts of PGMEA was placed, followed by stirring under nitrogen purge, and the temperature was increased to 80°C. 25 parts of dicyclopentanyl methacrylate, 26 parts of methyl methacrylate, 16 parts of methacrylic acid, and 14 parts of 2,2'-azobis(2,4-dimethylvaleronitrile) were dissolved in 110 parts of PGMEA, and the resulting solution was dropped through the dropping funnel into the flask, followed by stirring at 80°C for 3 hours.

Then, to the flask, 16 parts of glycidyl methacrylate, 0.4 parts of 2,2'-methylenebis(4-methyl-6-tert-butylphenol), and 0.8 parts of triphenylphosphine were added, followed by increasing the temperature to 110°C, and the system was stirred for 8 hours to thereby react the carboxylic acid of the polymer with the epoxy group to introduce a polymerizable unsaturated bond. Then, 17 parts of 1,2,3,6-tetrahydrophthalic anhydride was added, and the reaction was continued for 3 hours to introduce a carboxy group into the side chain. The reaction liquid was cooled to room temperature to obtain a solution of the resin (C1).

The resin (C1) had a weight average molecular weight Mw of 5200 in terms of standard polystyrene, a molecular weight distribution of 2.3, and an acid value of 100 mg KOH/g, and the solids content of the solution of the resin (C1) was 50% by mass.

<Examples 1 to 9, Comparative Example 1>

(1) Preparation of composition

A composition was prepared by mixing the dispersion of the first particle (A1a) obtained in Production Example 1 or the dispersion of the first particle (A1b) obtained in Production Example 2, the dispersion of the second particle (A2a) obtained in Production Example 3 or the dispersion of the second particle (A2b) obtained in Production Example 4, the solution of the resin (C1) obtained in Production Example 5, and other components shown in Table 1, in given amounts.

The contents of the components in the composition determined from the amounts added were shown in Table 1. In Table 1, the contents of the components other than the solvent (H) are that in terms of solids content (unit: parts by mass). The unit of the content of the solvent (H) was parts by mass. For example, although the first particle was added in the form of a dispersion thereof in the preparation of the composition, the content shown in Table 1 is the amount of the first particle

itself contained in the dispersion. The solvent (H) in Table 1 includes solvents contained in the dispersions and solutions used for the preparation of the composition.

The content of the organic ligand (G1) in the composition shown in Table 1 was calculated on the basis of the concentration of the organic ligand (G1) in the dispersion of the second particle obtained in Production Example 3 or 4, which was determined by the following method. Specifically, the dispersion of the second particle was dried in vacuo at 150°C to remove the medium, and on the remaining solids, the weight change was monitored from 50°C to 550°C at a temperature increasing rate of 5°C/min using a thermogravimetric analyzer "TGDTA6200". The weight change from 50°C to 500°C was used as the weight of the organic ligand (G1), from which the concentration of the organic ligand (G1) in the dispersion of the second particle was calculated.

(2) Preparation of film

The composition was applied to a 5 cm-square glass substrate (EAGLE 2000; manufactured by Corning Incorporated) by spin coating method such that the thickness became 6 μm. Then, the resultant was dried at 100°C for 3 minutes and further dried at 180°C for 10 minutes to form a film, thereby obtaining a substrate having a film.

For each of the compositions of Examples and Comparative Examples, the sedimentation velocity v was calculated. The change of the emission intensity, X, of the resulting film was also determined. The results are shown in Table 1.

[Table 1]

| | | Example | | | | | | | | | Comparative Example |
|---|---|---|---|---|---|---|---|---|---|---|---|
| | | 1 | 2 | 3 | 4 | 5 | 6 | 7 | 8 | 9 | 1 |
| First particle (A-1) | A1a | 2.01 | 2.30 | 2.49 | 1.53 | 2.01 | | | | 4.70 | 1.53 |
| | A1b | | | | | | 1.53 | 2.01 | 8.60 | | |
| Second particle (A-2) | A2b | 5.20 | 5.80 | 6.50 | | | 3.90 | 5.20 | 12.40 | 16.80 | 3.90 |
| | | | | | 3.20 | 4.20 | | | | | |
| Dispersant (B) | B1 | 0.09 | 0.10 | 0.11 | 0.07 | 0.09 | 0.07 | 0.09 | 0.40 | 0.20 | 0.07 |
| Organic ligand (G) | G1 | 0.80 | 1.00 | 1.10 | 1.40 | 1.80 | 0.60 | 0.80 | 2.30 | 2.80 | 0.60 |
| Resin (C) | C1 | 30.40 | 34.10 | 37.90 | 22.70 | 30.40 | 22.80 | 30.40 | 14.50 | 8.70 | 22.80 |
| Polymerizable compound (D) | D1 | | | | | | | | | 1.70 | |
| | D2 | | | | | | | | | 3.60 | |
| Polymerization initiator (E) | E1 | | | | | | | | | 0.50 | |
| Antioxidant (F) | F1 | 1.50 | 1.70 | 1.90 | 1.10 | 1.50 | 1.10 | 1.50 | 1.80 | 1.00 | 1.10 |
| Solvent (H) | H1 | 54.00 | 48.30 | 42.50 | 65.50 | 54.00 | 65.50 | 54.00 | 54.00 | 54.00 | 65.50 |
| | H2 | 6.00 | 6.70 | 7.50 | 4.50 | 6.00 | 4.50 | 6.00 | 6.00 | 6.00 | 4.50 |
| Total | | 100.00 | 100.00 | 100.00 | 100.00 | 100.00 | 100.00 | 100.00 | 100.00 | 100.00 | 100.00 |
| Solids content concentration (%) | | 40 | 45 | 50 | 30 | 40 | 30 | 40 | 40 | 40 | 30 |
| Liquid density ρ | $g/cm^3$ | 1.03 | 1.04 | 1.05 | 1.02 | 1.03 | 1.04 | 1.05 | 1.05 | 1.03 | 1.02 |
| Viscosity of composition, μ | g/(cm·s) | 1.37 | 4.84 | 11.65 | 0.31 | 1.64 | 0.26 | 1.58 | 0.86 | 0.18 | 0.19 |
| Sedimentation velocity v | $10^{-9}$ cm-s | 59 | 17 | 7 | 261 | 49 | 200 | 33 | 100 | 331 | 426 |
| Change of emission intensity, X (%) | | 105 | 104 | 101 | 86 | 105 | 98 | 106 | 98 | 83 | 79 |

Details of the abbreviations of the components shown in Tale 1 are as follows.

[1] Organic ligand (G): oleic acid
[2] Polymerizable compound (D1): ARONIX M-510 (photopolymerizable compound, carboxy group-containing polyfunctional (meth)acrylate, manufactured by TOAGOSEI CO., LTD., solids content 100%)
[3] Polymerizable compound (D2): A-9550 (photopolymerizable compound, dipentaerythritol polyacrylate, manufactured by SHIN-NAKAMURA CHEMICAL CO, LTD., solids content 100%)
[4] Polymerization initiator (E1): photopolymerization initiator represented by the following formula. It was manufactured by the method disclosed in Japanese Patent Laid-Open No. 2011-132215 (solids content 100%).

[Formula 23]

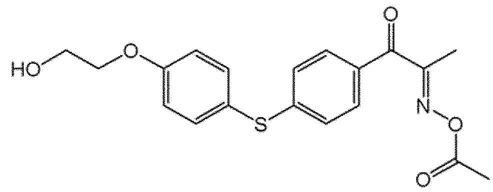

[5] Antioxidant (F1): Sumilizer-GP (phosphorus/phenol composite antioxidant, manufactured by Sumitomo Chemical Co., Ltd., solids content 100%)
[6] Solvent (H1): PGMEA (propylene glycol monomethyl ether acetate)
[7] Solvent (H2): cyclohexyl acetate

In all Examples, the film formed from the composition even left to stand for 10 days after the preparation exhibited an emission intensity comparable or close to the emission intensity of the film formed from the composition immediately after preparation, and thus showed less variation in the emission characteristics. In contrast, when a film was prepared from the composition of Comparative Example 1 left to stand for 10 days after the preparation, the film has a significantly poor emission intensity (change X = 79%), as compared to the film prepared from the composition of Comparative Example 1 immediately after preparation. The reason for this is probably that the first particle was settled because of the leaving the composition to stand for 10 days to thereby result in excess or firm aggregation thereof.
In some Examples, the change X was more than 100%. A possible reason for this is that the first particle might partly aggregate to increase the apparent particle diameter.

**Claims**

**1.** A composition comprising a particle, wherein

the particle includes: (A-1) a first particle having an average particle diameter d of $100 \times 10^{-7}$ cm or more,
the composition further comprises at least one selected from the group consisting of a resin (C) and a polymerizable compound (D), and
the composition has a sedimentation velocity v represented by a formula (i) of $400 \times 10^{-9}$ cm/s or less:
[Expression 1]

$$v = \frac{g(\rho_s - \rho)d^2}{18\mu} \qquad (i)$$

wherein g represents a gravitational acceleration [$cm/s^2$], $\rho_s$ represents a density [$g/cm^3$] of the first particle (A-1), $\rho$ represents a density [$g/cm^3$] of the same composition as above except that the particle is not contained therein, and $\mu$ is a viscosity [g/(cm-s)] of the composition at 25°C.

**2.** The composition according to claim 1, wherein the first particle (A-1) is a light-scattering particle.

**3.** The composition according to claim 1, wherein the first particle (A-1) is an inorganic particle.

4. The composition according to claim 1, wherein the particle further includes: (A-2) a second particle having an average particle diameter of $50 \times 10^{-7}$ cm or less.

5. The composition according to claim 4, wherein the second particle (A-2) is a light-emissive particle.

6. The composition according to any one of claims 1 to 5, wherein the resin (C) is a resin having a polar group, and the polymerizable compound (D) is a polymerizable compound having a polar group.

7. The composition according to claim 6, wherein the polar group is at least one group selected from the group consisting of a carboxy group, a thiol group, and an amino group.

8. The composition according to any one of claims 1 to 5, wherein the composition is for forming an optical functional film.

9. A film formed from the composition according to any one of claims 1 to 5.

10. A display device comprising the film according to claim 9.

# INTERNATIONAL SEARCH REPORT

International application No.
**PCT/JP2023/008023**

**A. CLASSIFICATION OF SUBJECT MATTER**

***C08L 101/00***(2006.01)i; ***C08K 3/00***(2018.01)i; ***C08K 7/18***(2006.01)i; ***C09K 11/02***(2006.01)i; ***G02B 5/20***(2006.01)i
FI: C08L101/00; C08K7/18; C09K11/02 Z; G02B5/20; C08K3/00

According to International Patent Classification (IPC) or to both national classification and IPC

**B. FIELDS SEARCHED**

Minimum documentation searched (classification system followed by classification symbols)

C08L101/00; C08K3/00; C08K7/18; C09K11/02; G02B5/20

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

Japio-GPG/FX

**C. DOCUMENTS CONSIDERED TO BE RELEVANT**

| Category* | Citation of document, with indication, where appropriate, of the relevant passages | Relevant to claim No. |
|---|---|---|
| A | JP 2005-281386 A (TORAY IND INC) 13 October 2005 (2005-10-13) | 1-10 |
| A | JP 2008-88270 A (BROTHER IND LTD) 17 April 2008 (2008-04-17) | 1-10 |
| A | JP 2019-163429 A (RICOH CO LTD) 26 September 2019 (2019-09-26) | 1-10 |
| A | JP 2008-101040 A (NISSAN CHEM IND LTD) 01 May 2008 (2008-05-01) | 1-10 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **01 May 2023** | **16 May 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | <br>Telephone No. |

Form PCT/ISA/210 (second sheet) (January 2015)

**INTERNATIONAL SEARCH REPORT**
**Information on patent family members**

International application No.
**PCT/JP2023/008023**

| Patent document cited in search report | Publication date (day/month/year) | Patent family member(s) | Publication date (day/month/year) |
|---|---|---|---|
| JP 2005-281386 A | 13 October 2005 | (Family: none) | |
| JP 2008-88270 A | 17 April 2008 | US 2008/0079794 A1 | |
| JP 2019-163429 A | 26 September 2019 | (Family: none) | |
| JP 2008-101040 A | 01 May 2008 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2014157296 A
- JP 2018123274 A
- JP 2011132215 A
- JP 2000080068 A
- JP 2011178776 A
- WO 2017051680 A
- WO 2020004601 A
- WO 200878678 A
- WO 200878686 A
- WO 2012132558 A
- JP 6075372 A
- JP 6075373 A
- JP 48038403 A
- JP 62174204 A
- JP 7010913 A
- JP 2006309219 A
- JP 2006310303 A
- JP 2013015812 A
- JP 2009251129 A
- JP 2014002363 A


### Non-patent literature cited in the description


- Experimental Method for Polymer Synthesis. Kagaku-Dojin Publishing Company, INC, 01 March 1972